(19) Europäisches Patentamt
European Patent Office
Office européen des brevets

(11) **EP 2 597 451 B1**

(12) **EUROPÄISCHE PATENTSCHRIFT**

(45) Veröffentlichungstag und Bekanntmachung des Hinweises auf die Patenterteilung:
**04.07.2018 Patentblatt 2018/27**

(51) Int Cl.:
***G01M 11/02*** *(2006.01)*

(21) Anmeldenummer: **12193668.6**

(22) Anmeldetag: **21.11.2012**

(54) **Verfahren und Vorrichtung zum Sichtbarmachen eines Signierzeichens auf einem Brillenglas**

Method and apparatus for the visualisation of signature on a spectacle lens

Procédé et dispositif de visualisation d'un signe de signature sur un verre de lunette

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.11.2011 DE 102011119806
25.11.2011 US 201161563661 P**

(43) Veröffentlichungstag der Anmeldung:
**29.05.2013 Patentblatt 2013/22**

(73) Patentinhaber: **Carl Zeiss Vision International GmbH
73430 Aalen (DE)**

(72) Erfinder:
• **Hanßen, Adalbert
73434 Aalen (DE)**
• **Hornauer, Matthias
73466 Lauchheim-Hülen (DE)**

(74) Vertreter: **Witte, Weller & Partner Patentanwälte mbB
Postfach 10 54 62
70047 Stuttgart (DE)**

(56) Entgegenhaltungen:
**EP-A2- 0 856 728      JP-A- 2006 015 447
US-A1- 2011 134 417**

EP 2 597 451 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Sichtbarmachen eines Signierzeichens auf einem Brillenglas, bei dem zum Erkennen des Signierzeichens ein Beleuchtungs-Lichtstrahl auf das Brillenglas gerichtet wird, der auf das Brillenglas trifft, nach dem Auftreffen auf das Brillenglases an einem als Retroreflektor ausgebildeten Reflektor reflektiert wird, erneut auf das Brillenglas trifft, und schließlich als Beobachtungs-Lichtstrahl einer Kamera zugeleitet wird.

Die Erfindung betrifft darüber hinaus eine Vorrichtung zum Sichtbarmachen eines Signierzeichens auf einem Brillenglas, mit einer auf einer ersten Seite des Brillenglases angeordneten Beleuchtungs-Lichtquelle zum Erzeugen eines Beleuchtungs-Lichtstrahles, für eine Erkennung des Signierzeichens, einem auf der der ersten Seite gegenüberliegenden Seite des Brillenglases angeordneten, als Retroreflektor ausgebildeten Reflektor, und einer Kamera zum Empfangen eines von dem Brillenglas kommenden Beobachtungs-Lichtstrahles.

Brillengläser, insbesondere sog. Gleitsichtgläser, werden mit Signierzeichen versehen, deren Lage während der Produktion des Brillenglases erfasst und verarbeitet wird, um das Brillenglas lagerichtig zu spannen, zu bearbeiten, zu stempeln und schließlich in die Brille des Endabnehmers zu bringen. Signierzeichen werden auf Brillengläsern gezielt und dauerhaft angebracht und zwar durch Diamantritzverfahren, durch Abformen beim Gießen von Kunststoff-Brillengläsern oder durch Lasersignierung. Daneben umfasst der Begriff "Signierzeichen" im Rahmen der vorliegenden Erfindung auch andere, nicht gezielt aufgebrachte Unregelmäßigkeiten des Brillenglases, z.B. Schlieren im Glasmaterial oder Kunststoff.

Wenn im Rahmen der vorliegenden Anmeldung von "Brillengläsern" die Rede ist, so sind darunter auch Haftschalen und andere vergleichbare optische Bauteile zu verstehen.

Damit der Brillenträger durch gezielt aufgebrachte Signierzeichen bei der Benutzung der Brille nicht gestört wird, sind diese Zeichen so gestaltet, dass sie nur bei sehr speziellen Lichtverhältnissen erkennbar sind. Die Erkennung der Lage eines Signierzeichens auf einem Brillenglas während des Produktionsprozesses ist deshalb schwierig. Erschwerend kommt dabei hinzu, dass die im Produktionsprozess befindlichen Brillengläser in Folge der speziellen Anforderungen der späteren Brillenträger sehr unterschiedliche optische Wirkungen haben. Innerhalb der Produktion folgen daher Brillengläser mit diesen unterschiedlichen optischen Wirkungen dicht aufeinander, die also in rascher Folge beim aufeinanderfolgenden Bearbeiten einzelner Brillengläser beachtet werden müssen.

Für eine Kontrolle von Gleitsichtgläsern im Fern- und Nahbezugspunkt ist es erforderlich, in Abhängigkeit von den aufgebrachten Signierzeichen die Wirkung der Gleitsichtgläser an festgelegten Koordinaten auf dem Brillenglas zu messen. Für eine manuelle oder für eine automatische Messung müssen die Signierzeichen daher sichtbar gemacht werden. Dies geschieht bei bekannten Verfahren und Vorrichtungen mittels rhombenförmiger Gitter oder Streifenmustern, die unscharf abgebildet werden und deren Kantenübergänge hell/dunkel das Signierzeichen erkennbar machen.

Nachteil dieser bekannten Vorgehensweise ist, insbesondere beim automatischen Erkennen der Signierzeichen, dass das Gitter je nach Wirkung des untersuchten Brillenglases unterschiedlich vergrößert abgebildet wird, nämlich in Abhängigkeit von der jeweiligen dioptrischen Wirkung des Brillenglases. Es ist daher erforderlich, für die Erkennung der Signierzeichen einen erheblichen Aufwand hinsichtlich der eingesetzten Algorithmen zu betreiben. Bekannte Verfahren haben bislang nicht zu einer vollständig sicheren automatischen Erkennung geführt. Es ist daher in der heutigen Praxis erforderlich, dass auch bei automatisierten Prüfanlagen eine speziell geschulte Arbeitskraft manuell in den Produktionsprozess eingreifen und Fehlerkennungen korrigieren muss.

Aber auch dann, wenn die Signierzeichen innerhalb eines Produktionsprozesses mittels eines manuellen Prüfvorganges erkannt werden, ist die Situation ähnlich. In diesem Falle wird je nach dem verwendeten Signierverfahren eine unterschiedliche Beleuchtung eingesetzt, um die Signierzeichen sichtbar zu machen. Bei bekannten Vorrichtungen geschieht dies durch Umstecken oder Umschalten von Beleuchtungseinheiten oder man führt das Brillenglas unter geeigneten Beleuchtungsbedingungen, z.B. einer entfernten Hell-Dunkel-Kante, vorbei und beobachtet es. Allerdings sind auch bei diesen Verfahren die Zeichen selber nur undeutlich zu erkennen, so dass Fehler bei der Positionierung und Ausrichtung des jeweiligen Brillenglases möglich sind. Dies gilt auch und gerade im Hinblick auf die für die Erkennung des Signierzeichens zur Verfügung stehende Zeit. Aus diesen Gründen ist es insbesondere bei der herkömmlichen Vorgehensweise zur Vorbereitung von Brillengläsern notwendig, die Brillengläser mittels eines Filzstiftes oder dgl. an der Stelle des Signierzeichens zu markieren ("anzupunkten"), was zusätzlichen Aufwand an Arbeit und Zeit erfordert.

Entsprechende Überlegungen gelten auch für einen anderen Bereich innerhalb der Bearbeitung derartiger Brillengläser, nämlich für Stempelautomaten, die nach dem heutigen Stand der Technik ebenfalls der Assistenz einer Bedienungsperson bedürfen. Diese beobachtet die Brillengläser auf einem Bildschirm, um nicht automatisch erkannte Positionen von Signierzeichen manuell im System zu korrigieren, beispielsweise mittels einer Rollkugel-Eingabe. Dieser Nachteil drückt sich ebenfalls in einer Verminderung der Produktivität der videounterstützten, manuell betätigten Stempelmaschinen aus.

Aus der US 3,892,494 sind ein Verfahren und eine Vorrichtung zum Auffinden von optischen Mikroeffekten an optischen Bauteilen, beispielsweise Linsen, bekannt. Dabei wird ein Laserstrahl durch einen Strahlenteiler, nämlich einen teildurchlässigen Spiegel, auf das zu untersuchende Bauteil gerichtet. Der Laserstrahl läuft durch das Bauteil hindurch und trifft auf der gegenüberliegenden Seite auf einen Retroreflektor, beispielsweise eine Retroreflexfolie, von dem er wieder durch das Bauteil hindurch reflektiert wird und denselben Strahlengang zurückläuft, bis er am Strahlenteiler ausgelenkt und auf eine Kamera gerichtet wird.

Nachteil dieser bekannten Vorgehensweise ist, dass sie bei Brillengläsern mit sehr unterschiedlicher Durchbiegung zu Problemen führen kann. Wegen der sehr unterschiedlichen Durchbiegung muss nämlich der Beobachtungsstrahlengang lang und außerdem abgeblendet sein, um eine ausreichende Schärfentiefe zu erhalten. Andererseits sollen die Strukturen des Retroreflektors aber nicht scharf abgebildet werden, da man zur Vermeidung von Fehlinterpretationen doch einen relativ homogenen Hintergrund haben möchte. Folglich muss der Retroreflektor bei diesen Anwendungen sehr weit hinter der Ebene des zu vermessenden Brillenglases liegen und er müsste außerdem sehr groß sein, weil stark negative Brillengläser den Retroreflektor stark verkleinert abbilden, so dass nicht mehr das ganze Glas über dem Retroreflektor gesehen werden kann.

Hinzu kommt, dass es im Rahmen der vorliegenden Erfindung nicht allein um das Erkennen von Signierzeichen und sonstigen Unregelmäßigkeiten auf Brillengläsern geht, sondern vielmehr um die Integration dieses Erkennungsprozesses in ein Messgerät oder in einen Bearbeitungsprozess. Dann ist aber hinter dem Brillenglas, also auf derselben Seite wie der Retroreflektor bei der bekannten Vorrichtung, ein Sensor angeordnet, um physikalische Eigenschaften des Brillenglases zu messen. Es ist daher aus konstruktiven Gründen nicht möglich, in diesem Fall den Retroreflektor sehr weit hinter der Ebene des Brillenglases anzuordnen.

Aus der US 4,310,242 ist eine Anordnung bekannt, um die optische Qualität von Windschutzscheiben an Ort und Stelle zu vermessen. Auch hier wird eine optische Anordnung mit einer Lichtquelle, einem Strahlenteiler, einem hinter der zu vermessenden Windschutzscheibe positionierten Retroreflektor sowie einer Kamera eingesetzt. Dabei wird durch den Strahlenteiler ein feines Muster auf einen retroreflektierenden Schirm projiziert, derart, dass auf dem retroreflektierenden Schirm ein reelles Bild dieses Musters entsteht, das durch die im Strahlengang befindliche Windschutzscheibe deformiert ist. Über den Strahlenteiler schaut nun die Kamera in Projektionsrichtung ebenfalls durch die zu prüfende Windschutzscheibe auf den retroreflektierenden Schirm. Inhomogenitäten, Spannungsdoppelbrechungen, Schlieren usw. werden auf diese Weise deutlich sichtbar.

Aus der DE 43 43 345 A1 sind Verfahren und Vorrichtungen zur Messung der reflektiven bzw. transmittierenden optischen Eigenschaften einer Probe bekannt. Dabei wird eine Messstrahlung auf eine Probe gerichtet, die von der Probe reflektiert wird, so dass sie auf einen Retroreflektor gelangt, der die Messstrahlung wieder über das Objekt zur Lichtquelle zurückschickt, wo eine Auskopplung zu einem Detektor stattfindet. Eine weitere ähnliche Vorgehensweise ist auch in der EP 0 169 444 A2 beschrieben.

Bei einem bekannten Scheitelbrechwert-Messgerät "Focovision SPV 1" wird ein Lichtstrahl von einer Lichtquelle durch ein Grünfilter geschickt und über einen Strahlenteiler auf das zu prüfende Brillenglas gerichtet. Der Lichtstrahl durchsetzt das Brillenglas und gelangt auf einen hinter der Rückseite des Brillenglases angeordneten Sensorkopf. Auf diese Weise können physikalische Eigenschaften des Brillenglases vermessen werden. Auf der Rückseite befindet sich ferner eine Ebene, in der austauschbare Beleuchtungszusätze angeordnet werden können. Diese Beleuchtungszusätze beleuchten das Brillenglas von hinten, so dass die Signierzeichen sichtbar werden. Ein entsprechender Beobachtungs-Lichtstrahl gelangt von dem Brillenglas zu dem Strahlenteiler, wird dort reflektiert und dann über weitere optische Mittel zu einer Kamera geführt. Bei einem ersten Beleuchtungszusatz wird ein sehr scharf begrenztes helles Lichtbündel unter einem flachen Winkel auf das Brillenglas gerichtet. Signierzeichen, die durch Kratzen hergestellt wurden, leuchten dann auf Grund der irregulären Gestalt der Kratzspur hell vor einem dunklen Hintergrund auf. Der zweite Beleuchtungszusatz ist hingegen für Brillengläser vorgesehen, deren Signierzeichen nicht durch Kratzen, sondern durch Abformen oder durch Laserstrahlen erzeugt worden sind. Dieser zweite Beleuchtungszusatz weist ein von unten beleuchtetes helles Liniengitter und mehrere nebeneinander angeordnete Hilfslinsen auf, mit denen diese leuchtenden Gitter nach unendlich abgebildet werden.

Die bekannte Vorrichtung ist daher relativ aufwändig in der Bedienung. Ferner fällt der Ort, an dem der von der Lichtquelle ausgesandte Messstrahl auf das Brillenglas fällt, mit dem Ort zusammen, an dem der Beobachtungs-Lichtstrahl aus dem Brillenglas austritt. Dies kann zu Störungen bei der Auswertung führen.

Aus der DE 197 40 391 ist noch eine Beobachtungsvorrichtung für verdeckte Markierungen, d.h. Signierungen, bekannt. Bei dieser Vorrichtung wird eine Linse, die mit der verdeckten Markierung versehen ist, mit einem Beleuchtungslicht beleuchtet. Die verdeckte Markierung wird dann als ein von dem Beleuchtungslicht gebildeter Schatten der Linse beobachtet.

Bei dieser Vorrichtung ist von Nachteil, dass die Markierung je nach Art der Linse durch deren lokale prismatische Wirkung verschoben oder durch die sammelnde bzw. zerstreuende Wirkung der Linse verkleinert bzw. vergrößert wird.

Des Weiteren zeigt die Druckschrift DE 103 33 426 A1 einen Aufbau nach dem Oberbegriff der unabhängigen Ansprüche. Dort wird vorgeschlagen den Retroreflektor zu bewegen, bspw. zu rotieren, um einen möglichst homogenen Hintergrund zu erlangen und die Strukturen des Retroreflektors zu verwischen.

Im Falle eines solchen, einfach rotierenden Retroreflektors ist seine Winkelgeschwindigkeit nahe der Rotationsachse sehr gering, so dass hier nur eine geringe Verwischung seiner Strukturen auftritt. Daher sollte der Retroreflektor möglichst eine Bewegung nach Art einer parallelen Drehtranslation, bspw. auf einer Zykloidenbahn, ausführen. Derartige Bewegungen sind jedoch, insbesondere wenn sie mit einer hohen Frequenz auszuführen sind, nur schwierig auszuwuchten, so dass der apparative Aufwand sehr groß ist.

Die Druckschrift JP 2006 015447 A zeigt eine Vorrichtung zum Prüfen, ob eine Polarisationsrichtung eines Brillenglases auf eine versteckte Kennzeichnung eingestellt ist.

Die Druckschrift US 2011/0134417 A1 zeigt eine Vorrichtung und ein Verfahren zum Charakterisieren eines optischen Systems.

Die Druckschrift EP 0 856 728 A2 zeigt eine optische Vorrichtung und ein Verfahren zum Erkennen von Defekten.

Der Erfindung liegt daher die Aufgabe zugrunde, Verfahren und Vorrichtungen der eingangs genannten Art dahingehend weiterzubilden, dass die genannten Nachteile vermieden werden. Insbesondere soll ermöglicht werden, Brillengläser innerhalb eines Produktionsprozesses so zu behandeln, dass die darauf angebrachten Signierzeichen lagerichtig erkannt werden. All dies soll mit möglichst einfachen apparativen und verfahrensmäßigen Mitteln geschehen.

Bei einem Verfahren der eingangs genannten Art wird diese Aufgabe erfindungsgemäß durch die Merkmale des Anspruchs 1 gelöst.

Bei einer Vorrichtung der eingangs genannten Art wird die Aufgabe erfindungsgemäß durch die Merkmale des Anspruchs 8 gelöst.

Wenn im Rahmen der vorliegenden Anmeldung von einem "Reflexionsbereich" die Rede ist, ist hiermit der Bereich auf der reflektierenden Oberfläche des Retroreflektors gemeint, in dem der Beleuchtungs-Lichtstrahl reflektiert wird. Ist der Beleuchtungs-Lichtstrahl beispielsweise in seinem Querschnitt kreisförmig und erfolgt die Ablenkung des Beleuchtungs-Lichtstrahls mittels eines keilförmigen Prismas als erstem optischen Element, weist der Reflexionsbereich auf der reflektierenden Oberfläche des Retroreflektors eine Ellipsenform auf. Bei einer Beeinflussung des Beleuchtungslichtstrahls beispielsweise mittels einer verkippten planparallelen Platte kann auch die Kreisform des Beleuchtungslichtstrahls in eine Kreisform des Reflexionsbereichs überführt werden.

Wenn im Rahmen der vorliegenden Anmeldung von einem "Retroreflektor" die Rede ist, so ist hierunter eine Fläche zu verstehen, die einfallendes Licht über einen großen Bereich von Einfallswinkeln im Wesentlichen wieder in dieselbe Richtung zurückwirft, aus der es einfällt. In der Praxis verwendet man hierfür ebene oder gekrümmte Flächen, die mit einer retroreflektierenden Oberfläche, z.B. Glasperlen, versehen sind, oder auf der viele kleine Tripelspiegel oder verspiegelte Tripelprismen in einer regelmäßigen Anordnung angebracht sind. Derartige Oberflächen sind allgemein von Fahrzeug-Rückreflektoren, Verkehrsschildern, Lichtschranken usw. bekannt. Für das erfindungsgemäße Verfahren ist es vorteilhaft, wenn die einzelnen retroreflektierenden Strukturen auf dem Retroreflektor deutlich kleiner als 1 mm sind.

Unter "variiert" wird im Rahmen der vorliegenden Anmeldung verstanden, dass sich der Ort des Reflexionsbereichs auf dem Retroreflektor zeitlich ändert. Dabei kann seine Form, Größe und Orientierung jedoch unverändert bleiben.

Die Merkmale "nach dem Brillenglas auftreffen" und "nach dem Brillenglas angeordnet" beziehen sich im Rahmen dieser Anmeldung auf die Reihenfolge in einem Strahlengang des Beleuchtungs-Lichtstrahls. Der Beleuchtungs-Lichtstrahl trifft somit zunächst auf das Brillenglas auf, wobei der Beleuchtungs-Lichtstrahl das Brillenglas dann transmittieren (durchlaufen) kann oder von diesem reflektiert werden kann. Der Begriff "auftreffen" kann somit als "transmittieren oder reflektieren" verstanden werden. Dann trifft der Beleuchtungs-Lichtstrahl auf das erste optische Element auf. Auch das erste optische Element kann der Beleuchtungs-Lichtstrahl transmittieren (durchlaufen) oder von diesem reflektiert werden. Danach wiederum wird der Beleuchtungs-Lichtstrahl von dem Retroreflektor reflektiert.

Das vorgeschlagene Verfahren und die vorgeschlagene Vorrichtung können also in einem transmittiven oder einem reflektierenden Aufbau vorgesehen sein.

Bei dem transmittiven Aufbau durchläuft der Beleuchtungs-Lichtstrahl das Brillenglas und durchläuft es als Beobachtungs-Lichtstrahl erneut. Das erste optische Element ist dann auf der der ersten Seite gegenüberliegenden Seite des Brillenglases angeordnet.

Die "erste Seite" des Brillenglases ist dabei diejenige Seite des Brillenglases, auf der die Beleuchtungs-Lichtquelle zum Erzeugen eines Beleuchtungs-Lichtstrahles angeordnet ist bzw. die zu der Beleuchtungs-Lichtquelle weist. Der Beleuchtungs-Lichtstrahl trifft von der ersten Seite kommend auf das Brillenglas auf.

Bei dem reflektierenden Aufbau wird der Beleuchtungs-Lichtstrahl von dem Brillenglas, insbesondere seiner der Beleuchtungs-Lichtquelle abgewandten Oberfläche, reflektiert und als Beobachtungs-Lichtstrahl erneut von dem Brillenglas reflektiert. Das erste optische Element ist dann auf der ersten Seite des Brillenglases angeordnet. Dabei ist auf die Einhaltung der Scheimpflugbedingung zu achten. Bei einer Einhaltung der Scheimpflugbedingung schneiden sich die Bildebene und die Objektivebene bzw. Objektivhauptebene der Kamera und die Schärfeebene in einer Geraden. Die Schärfebene wäre im Fall des reflektierenden Aufbaus die nominelle Ebene des Brillenglases. Daher sind die Kamera, der Retroreflektor und das Brillenglas, bzw. eine nominelle Ebene des Brillenglases, derart anzuordnen, dass die Scheimpflugbedingung für die Abbildung des Brillenglases in der Kamera erfüllt ist. Dann erfolgt eine scharfe Abbildung der nominellen Ebene des Brillenglases.

Nach dem Auftreffen auf das Brillenglas kann der Beleuchtungs-Lichtstrahl das Brillenglas somit entweder durchlaufen oder von diesem reflektiert werden. Das erste optische Element kann entweder auf der der ersten Seite gegenüberliegenden Seite des Brillenglases angeordnet sein. Alternativ kann das erste optische Element auf der ersten Seite des Brillenglases angeordnet sein.

Wenn der Reflexionsbereich auf dem Reflektor bewegt wird, so wird ein homogener Hintergrund erzeugt, von dem sich die Signierzeichen wesentlich deutlicher und damit kontrastreicher abheben. Die zu prüfenden Brillengläser erscheinen bei der Messung gleichmäßig hell. An den Kanten der Signierzeichen tritt jedoch eine so starke Streuung auf, dass das gestreute Licht nicht mehr die Retroreflexbedingung erfüllt, mit der Folge, dass die Signierzeichen dunkel auf hellem Hintergrund erscheinen. Durch die Bewegung des ersten optischen Element und damit des Reflexionsbereichs auf dem Retroreflektor verschwimmt die Struktur des Retroreflektors und es stören Wellen, Inhomogenitäten, Verschmutzungen usw. des Retroreflektors selbst nicht mehr.

Handelt es sich bei den "Signierzeichen" um nicht gezielt aufgebrachte Unregelmäßigkeiten des Brillenglases, z.B. Schlieren im Glasmaterial oder Kunststoff, so lassen sich diese mittels des vorgeschlagenen Verfahrens und der vorgeschlagenen Vorrichtung sichtbar machen und so das Brillenglas auf seine Qualität hin überprüfen.

Ist das optische Element beispielsweise als rotierendes keilförmiges Prisma ausgebildet, wird ein auf das erste optische Element einfallender Beleuchtungs-Lichtstrahl um einen gewissen Winkel abgelenkt. Aufgrund der Rotation des keilförmigen Prismas beschreiben der Beleuchtungs-Lichtstrahl bzw. dessen Reflexionsbereich auf dem Retroreflektor dann Kreise. Der Radius dieser Kreise hängt vom Keilwinkel und vom Abstand des ersten optischen Elements zum Retroreflektor ab. Wenn man den Retroreflektor nun durch das rotierende keilförmige erste optische Element betrachten würde, würde es so aussehen, als bewegte sich der Retroreflektor nach Art einer parallelen Drehtranslation, obwohl der Retroreflektor tatsächlich feststeht. Auf diese Weise kann man somit eine "virtuelle Bewegung" des Retroreflektors erzielen, ohne diesen aber tatsächlich bewegen zu müssen. Dies vereinfacht wesentlich den apparativen Aufbau, da eine Bewegung eines Retroreflektors auf einer Zykloidenbahn oder auf einer parallelen Drehtranslation, sehr aufwendig zu installieren oder auszuwuchten ist. Demgegenüber ist das Auswuchten einer Rotationsbewegung eines keilförmigen Prismas deutlich einfacher. Das keilförmige Prisma ist außen zu lagern, beispielsweise in einem Außenring eines Kugellagers. Außen am Ring kann eine geeignete Kupplung mit einer Antriebseinrichtung angreifen, die das keilförmige Prisma rotiert.

Auf diese Weise wird ein deutlich einfacherer technischer apparativer Aufbau erzielt, der aufgrund des geringeren Aufwands für das Auswuchten schneller in Betrieb zu nehmen ist.

Des Weiteren lässt sich auf diese Weise, beispielsweise mittels der Ausgestaltung des ersten optischen Elements als keilförmiges Prisma oder als eine verkippte planparallele Platte, mit sehr geringem Aufwand vermeiden, dass Teile des Beleuchtungslichtstrahls nur wenig oder gar nicht verwischt werden.

Die der Erfindung zugrunde liegende Aufgabe wird auf diese Weise vollkommen gelöst.

Des Weiteren ist vorgesehen, dass der Retroreflektor feststeht. Unter "feststeht" ist dabei zu verstehen, dass sich der Retroreflektor nicht bewegt. Insbesondere bewegt sich der Retroreflektor weder translatorisch noch rotatorisch relativ zu der Brillenlinse bzw. der Beleuchtungs-Lichtquelle bzw. der Kamera.

Auf diese Weise wird ein einfacher apparativer Aufbau erreicht. Es wird vermieden, dass der Retroreflektor auf irgendeine Weise gelagert und angetrieben werden muss. Alternativ kann selbstverständlich auch vorgesehen sein, dass der Retroreflektor zusätzlich zu dem ersten optischen Element bewegt wird, um den Effekt des Verwischens der Strukturen des Retroreflektors zu verstärken. Dabei kann der Retroreflektor beispielsweise linear oder rotatorisch bewegt werden.

In einer weiteren Ausführungsform des Verfahrens kann vorgesehen sein, dass der Reflexionsbereich des Beleuchtungs-Lichtstrahls auf dem Reflektor bzw. Retroreflektor linear bewegt wird. Dabei kann vorgesehen sein, dass ein Einfallswinkel des Beleuchtungs-Lichtstrahls auf das erste optische Element variiert wird, wobei das erste optische Element relativ zu dem Beleuchtungs-Lichtstrahl oszillierend verkippt wird.

Entsprechend kann auch bei der Vorrichtung in einer Ausführungsform vorgesehen sein, dass die Vorrichtung eine Antriebseinrichtung aufweist, die derart mit dem ersten optischen Element gekoppelt ist, dass sie das erste optische Element relativ zu dem Beleuchtungs-Lichtstrahl oszillierend verkippt, um einen Einfallswinkel des Beleuchtungs-Lichtstrahls auf das erste optische Element zu variieren.

Unter Umständen kann bereits eine resultierende lineare Bewegung des Reflexionsbereichs auf dem Retroreflektor ausreichen, um einen ausreichenden Verwischungseffekt herbeizurufen. Ein oszillierendes Verkippen des ersten optischen Elements kann abhängig von dem übrigen apparativen Aufbau unter Umständen einfacher mechanisch zu verwirklichen sein. Des Weiteren kann auf diese Weise abhängig vom apparativen Aufbau der Strahlengang des Beleuchtungs-Lichtstrahls eventuell derart abgelenkt bzw. beeinflusst werden, dass die gesamte räumliche Anordnung der Vorrichtung klein ist. Beispielsweise wird auf diese Weise ermöglicht, den Retroreflektor bzw. dessen reflektierende Oberfläche parallel zu einer optischen Achse des Brillenglases anzuordnen.

In einer weiteren Ausführungsform des Verfahrens kann vorgesehen sein, dass der Reflexionsbereich des Beleuchtungs-Lichtstrahls auf den Reflektor kreisförmig oder ellipsenförmig bewegt wird. Dabei kann vorgesehen sein, dass das erste optische Element um eine, insbesondere im Wesentlichen, parallel zu einer optischen Achse des Brillenglases verlaufende Achse rotiert wird. Die optische Achse ist die Gerade, auf der die beiden optischen Flächen, die Vorder- und die Rückseite, des Brillenglases senkrecht stehen und entlang welcher Licht das Brillenglas unabgelenkt durchtritt. Im Falle eines asphärischen Brillenglases ist unter der optischen Achse die Rotationsachse des Brillenglases zu verstehen.

Entsprechend kann auch bei einer Ausführungsform der Vorrichtung vorgesehen sein, dass die Vorrichtung eine Antriebseinrichtung aufweist, die derart mit dem ersten optischen Element gekoppelt ist, dass sie das erste optische Element um eine, insbesondere im Wesentlichen, parallel zu einer optischen Achse des Brillenglases verlaufende Achse rotiert.

Auf diese Weise können Brillenglas, erstes optisches Element und Retroreflektor hintereinander angeordnet werden. Insbesondere kann hierbei der Abstand zwischen dem Retroreflektor und dem ersten optischen Element dazu genutzt werden, einen Radius des Kreisbogens, den der Reflexionsbereich auf dem Retroreflektor beschreibt, zu vergrößern. Des Weiteren kann eine derartige Bewegung in der Regel einfacher beispielsweise mit einer Frequenz einer Kamera synchronisiert werden. Letztlich kann diese Bewegungsart des ersten optischen Elements auch bei hohen Frequenzen der Bewegung einen ruhigeren Lauf zur Folge haben als dies bei einem Hin- und Herverkippen der Fall wäre.

Das erste optische Element ist derart ausgestaltet, dass es den Beleuchtungs-Lichtstrahl ablenkt. Vorzugsweise handelt es sich bei dem ersten optischen Element um ein Prisma mit keilförmiger Grundplatte. Es kann sich bei dem ersten optischen Element aber beispielsweise auch um eine zu einer optischen Achse des Brillenglases verkippte planparallele Platte oder eine Platte mit mindestens einer wellenförmigen Oberfläche handeln. Bei dem Fall der Platte mit mindestens einer wellenförmigen Oberfläche ist darauf zu achten, dass die Oberfläche auf der optischen Achse bzw. der Rotationsachse der Platte nicht senkrecht zu der optischen Achse bzw. der Rotationsachse steht, sondern dass auch hier eine Ablenkung stattfindet.

Im Falle einer derartigen Ausgestaltung des ersten optischen Elements tritt der Beleuchtungs-Lichtstrahl durch das erste optische Element hindurch. Insofern ist es das erste optische Element außen zu lagern und anzutreiben, damit die entsprechenden Lagerung und Kopplungen bzw. Antriebselemente sich nicht in dem Strahlengang des Beleuchtungs-Lichtstrahls befinden. Beispielsweise kann das erste optische Element in einem Außenring rotierbar gelagert sein. Das erste optische Element kann dann beispielsweise durch Einblasen von Druckluft in dem Lagerring rotiert werden. Es kann aber auch vorgesehen sein, dass das erste optische Element fest mit einem Außenring verbunden ist und der Außenring wiederum an seiner Außenseite mechanisch angetrieben wird. Beispielsweise kann dies direkt mittels eines geeigneten Rads geschehen oder aber durch Umschlingung des Außenrings mit einem entsprechenden endlosen Kraftübertragungselement, beispielsweise eines Riemens oder einer Kette oder aber magnetisch, indem der Außenring durch ein umlaufendes magnetisches Feld angetrieben ist, ähnlich wie der rotierende Teil eines Drehstrommotors.

Des Weiteren kann vorgesehen sein, dass das erste optische Element ein Spiegel ist. Insbesondere kann dabei vorgesehen sein, dass das erste optische Element ein Spiegel ist, der taumelnd rotiert wird.

Bei einer taumelnden Rotation steht die Rotationsachse schräg auf der spiegelnden Oberfläche des Spiegels.

Hierbei kann sich der Vorteil ergeben, dass eine Lagerung bzw. ein Antrieb des Spiegels nicht etwa über einen Außenring erfolgen muss, sondern auf beliebige Weise an der Rückseite des Spiegels erfolgen kann. Eventuell kann ein solcher Aufbau apparativ vorteilhaft sein. Des Weiteren ändert ein Spiegel bspw. nicht die optischen Eigenschaften eines Mess-Lichtstrahls, der durch das Brillenglas tritt. In dem Fall, dass parallel eine optische Eigenschaft des Brillenglases ermittelt werden soll, kann somit ein Spiegel als erstes optisches Element vorteilhaft sein.

Des Weiteren kann mindestens ein optisches Führungselement zum Führen des Beleuchtungs-Lichtstrahles durch das Brillenglas hindurch und zum Führen des von dem Reflektor durch das Brillenglas hindurch reflektierten Beobachtungs-Lichtstrahles zu der Kamera vorgesehen sein.

Des Weiteren kann eine Ausführungsform der Vorrichtung vorgesehen sein, dass das optische Führungselement mindestens ein zweites optisches Element zum Führen des Beleuchtungs-Lichtstrahles durch das Brillenglas hindurch und mindestens ein drittes optisches Element zum Führen des von dem Reflektor durch das Brillenglas hindurch reflektierten Beobachtungs-Lichtstrahles zu der Kamera aufweist.

Auf diese Weise lassen sich komplexere Strahlengänge für den Beleuchtungs-Lichtstrahl und den Beobachtungs-Lichtstrahl realisieren.

Des Weiteren kann in einer Ausführungsform des Verfahrens vorgesehen sein, dass ferner zum Messen einer physikalischen Eigenschaft des Brillenglases ein Mess-Lichtstrahl auf das Brillenglas gerichtet und dann einem Sensor zugeleitet wird, und dass der Mess-Lichtstrahl von einer ersten Lichtquelle und der Beleuchtungs-Lichtstrahl von einer zweiten Lichtquelle erzeugt wird, die baulich verschiedene Einheiten sind.

Entsprechend kann in einer Ausführungsform der Vorrichtung eine von der Beleuchtungs-Lichtquelle baulich verschiedene Mess-Lichtquelle zum Erzeugen eines Mess-Lichtstrahls für eine Messung einer physikalischen Eigenschaft des Brillenglases, ein Sensor und mindestens ein viertes optisches Element zum Führen des Mess-Lichtstrahls von der Mess-Lichtquelle zu dem Brillenglas und vom Brillenglas zu dem Sensor vorgesehen sein.

Durch die Maßnahme, für den Strahlengang des Mess-Lichtes und des Beleuchtungs-Lichtes unterschiedliche bauliche Komponenten und zumindest teilweise auch unterschiedliche Strahlengänge einzusetzen, lässt sich eine Entkopplung der Vorgänge des Messens physikalischer Eigenschaften des Brillenglases sowie des Erkennens von Signierzeichen auf dem Brillenglas sauber voneinander trennen.

Das erfindungsgemäße Verfahren und die erfindungsgemäße Vorrichtung mit einem bewegten optischen Element lassen sich in erfindungsgemäßer Weiterbildung mit einem Scheitelbrechwert-Messgerät kombinieren, so dass man damit die Messung leicht an den Stellen auf dem Brillenglas ausführen kann, deren Lage relativ zu den Signierzeichen auf dem Brillenglas definiert ist. Dazu kombiniert man das erfindungsgemäße Verfahren so mit dem Scheitelbrechwert-Messgerät, dass das Bild der Signierzeichen im Kamerabild eine bestimmte Position einnehmen muss, während man die Messung ausführt. Man verwendet dazu einen Beleuchtungs-Strahlengang und einen Mess-Strahlengang, die sich in der näher ausgeführten Weise optisch entkoppeln lassen, obwohl sie teilweise dieselben Pfade verwenden.

Bei Ausführungsformen des Verfahrens und der Vorrichtung kann auch der Reflektor im Wesentlichen periodisch bewegt werden, insbesondere rotierend. Alternativ ist aber auch eine Bewegung in einer parallelen Drehtranslation möglich, bei der der Retroreflektor z.B. in einer Ebene verschoben wird und sein Mittelpunkt sich dabei auf einer Kreisbahn bewegt, ohne dass der Retroreflektor im Übrigen gedreht wird. Daneben ist auch eine lineare Bewegung des Retroreflektors möglich. All diese Bewegungen verlaufen im Wesentlichen quer zur Ausbreitungsrichtung des Beleuchtungs-Lichtstrahles.

Auch das erste optische Element kann periodisch bewegt werden bzw. derart angetrieben werden, das der Reflexionsbereich auf dem Reflektor eine periodische Bewegung ausführt.

Wenn der Reflektor und/oder das erste optische Element periodisch bewegt wird, besteht eine weitere bevorzugte Ausführungsform der Erfindung darin, die Frequenz dieser periodischen Bewegung an ein Synchronisiersignal der Kamera anzupassen. Insbesondere ist bevorzugt, wenn die Frequenz mit dem Synchronisiersignal drehzahlsynchronisiert, insbesondere phasensynchronisiert wird.

Diese Maßnahme hat den Vorteil, dass die elektronische Auswertung des aus dem Beobachtungs-Lichtstrahl abgeleiteten Videosignals in besonders einfacher Weise möglich ist, weil eine Verwischung der Strukturen des Retroreflektors dann in allen aufgenommenen Bildern bzw. Videoframes gleich gut ist.

Bei einer weiteren Gruppe von Ausführungsbeispielen wird eine gute Wirkung dadurch erzielt, dass der Reflektor in einem Abstand von 1 cm bis 30 cm vom Brillenglas angeordnet ist. Mit anderen Worten soll eine Länge des Strahlengangs des Beleuchtungs-Lichtstrahls von dem Brillenglas zu dem Reflektor etwa 1 cm bis 30 cm betragen. Diese Maßnahme hat den Vorteil, dass sich ein besonders gleichmäßiger Hintergrund durch den bewegten Retroreflektor ergibt. Dabei liegt eine gedachte Flächennormale des Reflektors nicht zwingend genau parallel zu der optischen Achse der Beleuchtung.

Eine besonders gute Wirkung wird ferner dann erzielt, wenn ein in der Kamera aus dem Beobachtungs-Lichtstrahl erzeugtes Videosignal durch mindestens eine Faltungsoperation über jeweils endliche Nachbarschaften im Kontrast angehoben wird. Vorzugsweise werden dabei hohe Ortsfrequenzen, z.B. infolge einer differenzierenden Wirkung, stärker angehoben als niedrige Ortsfrequenzen.

Das aus dem Beobachtungs-Lichtstrahl erzeugte Videosignal in der Kamera kann erfindungsgemäß zu verschiedenen Zwecken verwendet werden. Zum einen kann es zum Ermitteln des Signierzeichens mittels Zeichenerkennung dienen. Zum anderen kann es zum Positionieren des Brillenglases auf einer Auflage dienen und anschließend zum Ermitteln einer dioptrischen Wirkung des Brillenglases.

Die verschiedenen Strahlengänge können ganz oder streckenweise zusammengelegt werden, um das Verfahren auf möglichst kleinem Raum durchführen zu können.

Bei einer ersten Variante wird der Beleuchtungs-Lichtstrahl in den Strahlengang des Beobachtungs-Lichtstrahles eingekoppelt. Bei einer zweiten Variante wird der Mess-Lichtstrahl in den Strahlengang des Beobachtungs-Lichtstrahles eingekoppelt. Bei einer dritten Variante schließlich wird der Mess-Lichtstrahl in den Strahlengang des Beleuchtungs-Lichtstrahles eingekoppelt.

Dies geschieht bei Ausführungsformen der erfindungsgemäßen Vorrichtung bevorzugt durch entsprechende Strahlenteiler oder sonstige geeignete optische Mittel, beispielsweise durchbohrte Spiegel.

Im Zusammenhang mit den verwendeten Strahlenteilern ist es bevorzugt, eine Lichtfalle für einen durch den Strahlenteiler hindurchtretenden Anteil des jeweiligen Lichtstrahls vorzusehen.

Wenn ein Strahlenteiler zum Einkoppeln des Beleuchtungs-Lichtstrahls in den Strahlengang des Beobachtungs-Lichtstrahles vorgesehen ist, geschieht dies in bevorzugter Weise derart, dass eine Eintrittspupille der Kamera und eine Austrittspupille der Beleuchtungs-Lichtquelle oder die Beleuchtungs-Lichtquelle oder ein Bild davon konjugiert zu diesem Strahlenteiler sind.

Erfindungsgemäß ist weiterhin bevorzugt, wenn der Beleuchtungs-Lichtstrahl mindestens im Auftreffbereich des Mess-Lichtstrahles auf dem Brillenglas ausgeblendet wird. Diese Maßnahme hat den Vorteil, dass Wechselwirkungen vermieden werden, die dadurch auftreten können, dass der Beleuchtungs-Lichtstrahl auf den Sensor fällt, der nur den Mess-Lichtstrahl empfangen sollte.

Dabei ist besonders bevorzugt, wenn der Beleuchtungs-Lichtstrahl als im Querschnitt ringförmiger Lichtstrahl erzeugt wird. Dies geschieht apparativ bevorzugt dadurch, dass entweder die Beleuchtungsquelle bereits einen im Querschnitt ringförmigen Beleuchtungs-Lichtstrahl erzeugt oder aber dass die Beleuchtungs-Lichtquelle ein Dia mit einem lichtundurchlässigen Punkt im Strahlengang des Beleuchtungs-Lichtstrahles aufweist.

Bei weiteren bevorzugten Ausführungsformen der Erfindung weisen der Beleuchtungs-Lichtstrahl und der Mess-Lichtstrahl unterschiedliche Lichtwellenlänge auf. Auch diese Maßnahme hat den Vorteil, dass beide Lichtstrahlen hinsichtlich der elektronischen Weiterverarbeitung exakt voneinander getrennt werden können. Bevorzugt werden der Beleuchtungs-Lichtstrahl als rotes Licht, d.h. insbesondere in einem Wellenlängenbereich von 650 bis 750 nm, und der Mess-Lichtstrahl als grünes Licht, d.h. insbesondere in einem Wellenlängenbereich von 490 nm bis 575 nm, erzeugt.

Ferner ist bevorzugt möglich, dass der auf den Sensor fallende Mess-Lichtstrahl durch ein Filter geleitet wird, das für die Lichtwellenlänge des Beleuchtungs-Lichtstrahles als Sperrfilter wirkt. Auch diese Maßnahme trägt dazu bei, die beiden Strahlengänge voneinander zu trennen.

Der Retroreflektor kann eben oder gewölbt ausgebildet sein. Insbesondere kann der Retroreflektor in Richtung des auf ihn einfallenden BeleuchtungsLichtstrahls bzw. in Richtung des Brillenglases gewölbt sein.

Darüber hinaus kann in allen Ausführungsformen in dem Strahlengang des Beleuchtungs-Lichtstrahls zwischen dem Brillenglas und dem Retroreflektor mindestens ein fünftes optisches Element angeordnet sein, das insbesondere eine sphärische Wirkung aufweisen kann. Auf diese Weise kann der Strahlengang des Beleuchtungs-Lichtstrahles insbesondere derart beeinflusst werden, dass der Beleuchtungs-Lichtstrahl vollständig auf den Retroreflektor fällt. Insbesondere bei Brillengläsern mit stark zerstreuender Wirkung und relativ kleinen Retroreflektoren kann dies notwendig sein, um einen großen Anteil des Beleuchtungs-Lichtstrahls bzw. den gesamten Beleuchtungs-Lichtstrahl auf den Retroreflektor zu lenken.

Weitere Vorteile ergeben sich aus der Beschreibung und der beigefügten Zeichnung.

Ausführungsbeispiele der Erfindung sind in der Zeichnung dargestellt und werden in der nachfolgenden Beschreibung näher erläutert. Es zeigen:

Fig. 1          eine äußerst schematisierte Seitenansicht eines ersten Ausführungsbeispiels einer erfindungsgemäßen Vorrichtung;

Fig. 2          eine ebenfalls schematisierte Seitenansicht eines zweiten Ausführungsbeispiels einer erfindungsgemäßen Vorrichtung, nämlich eines Scheitelbrechwert-Messgeräts, wobei zusätzlich optische Mittel zum Vermessen eines Brillenglases vorgesehen sind;

Fig. 3-5          drei Ausführungsformen von Beleuchtungs-Lichtquellen, wie sie bei den Ausführungsformen gemäß Fig. 1 und 2 Verwendung finden können;

Fig. 6          in vergrößertem Maßstab eine Draufsicht auf einen Retroreflektor, wie er bei der Vorrichtung gemäß Fig. 1 verwendet wird, und eine mögliche Bewegung eines Reflexionsbereichs;

Fig. 7          eine schematisierte Seitenansicht zur Erläuterung einer weiteren Möglichkeit zur Einkopplung von Beleuchtungslicht;

Fig. 8a bis 8d          schematische Ansichten von Ausführungsformen des ersten optischen Elements; und

Fig. 9          eine äußerst schematisierte Seitenansicht eines zweiten Ausführungsbeispiels einer erfindungsgemäßen Vorrichtung.

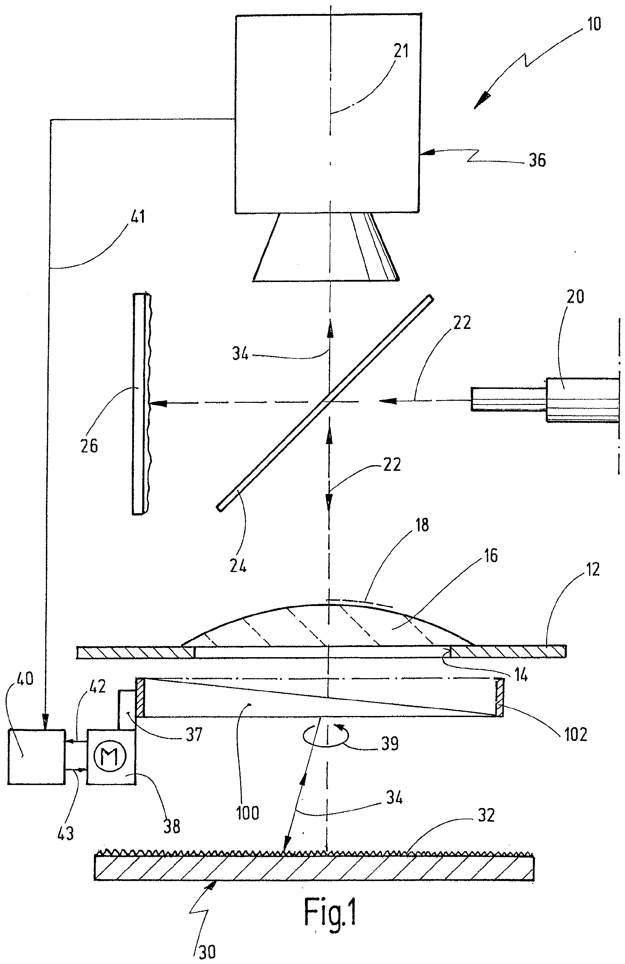

In Fig. 1 bezeichnet 10 insgesamt ein erstes Ausführungsbeispiel einer erfindungsgemäßen Vorrichtung.

In der Vorrichtung 10 ist eine Auflage 12 mit einer zentralen Aussparung 14 vorgesehen. Auf der Auflage 12 und über die Aussparung 14 hinweg befindet sich ein Brillenglas 16. Das Brillenglas 16 ist mit einem bei 18 angedeuteten Signierzeichen versehen.

Eine Beleuchtungs-Lichtquelle 20 ist vorzugsweise senkrecht zur optischen Achse des Brillenglases 16 ausgerichtet, die im dargestellten Beispiel mit der optischen Achse 21 einer Kamera 36 zusammenfällt. Die Beleuchtungs-Lichtquelle 20 sendet einen Beleuchtungs-Lichtstrahl 22 aus. Dieser gelangt auf einen Strahlenteiler 24, beispielsweise einen teildurchlässigen Spiegel, und wird dort in die Richtung der optischen Achse 21 der Kamera 36 reflektiert. Ein durch den Strahlenteiler 24 hindurchtretender Anteil des aus der Beleuchtungs-Lichtquelle 20 austretenden Beleuchtungs-Lichtstrahls 22 wird von einer Lichtfalle 26 absorbiert, die hinter dem Strahlenteiler 24 angeordnet ist.

Der Beleuchtungs-Lichtstrahl 22 durchsetzt das Brillenglas 16 und durchläuft ein erstes optisches Element 100, das in der Darstellung gemäß Fig. 1 unterhalb des Brillenglases 16 bzw. im Strahlengang des Beleuchtungs-Lichtstrahls 22 nach dem Brillenglas angeordnet ist. Das erste optische Element 100 ist als Prisma mit keilförmiger Grundfläche ausgebildet. Folglich wird der Beleuchtungs-Lichtstrahl 22 abhängig von dem Keilwinkel des ersten optischen Elements 100 abgelenkt. Anschließend trifft der Beleuchtungs-Lichtstrahl 22 auf einen Retroreflektor 30.

Der Retroreflektor 30 ist mit einer retroreflektierenden Beschichtung 32 versehen. Er kann auch als handelsübliche Retroreflexfolie oder als Retroreflektor mit regelmäßig angeordneten Tripelspiegeln oder verspiegelten Tripelprismen ausgebildet sein.

Der vom Retroreflektor 30 reflektierte Beleuchtungs-Lichtstrahl 22 durchläuft erneut - in entgegengesetzter Richtung - das erste optische Element 100, das Brillenglas 16 und wird dann als Beobachtungs-Lichtstrahl 34 zu der Kamera 36, beispielsweise einer CCD-Kamera geführt. Die Kamera 36 ist auf das Brillenglas 16 fokussiert und erzeugt ein Bild des Brillenglases 16, in dem das Signierzeichen 18 vor dem Hintergrund des Retroreflektors 30 sichtbar ist.

Das erste optische Element 100 ist über eine nur schematisch angedeutete Wirkverbindung 37, im dargestellten Beispiel eine Welle, mit einem Antriebsmotor 38 verbunden. Der Antriebsmotor 38 dreht das erste optische Element 100 um eine Vertikalachse, die mit der Achse 21 der Kamera 30 sowie mit der Achse des Beleuchtungs-Lichtstrahls 22 vorzugsweise fluchtet. Dies ist in Fig. 1 mit einem Pfeil 39 veranschaulicht.

Da der Beleuchtungs-Lichtstrahl 22 durch das erste optische Element 100 hindurchtritt, ist das erste optische Element 100 derart zu lagern, dass die Lagerung sowie die Wirkverbindung 37 und der Antriebsmotor 38 nicht in dem Strahlengang des Beleuchtungslichtstrahls 22 angeordnet sind. Hierzu ist ein Außenring 102 vorgesehen, in den das erste optische Element 100 eingespannt ist. Hier kann beispielsweise vorgesehen sein, dass das erste optische Element 100, in einem Außenring eines Kugellagers gelagert ist. Ein Prisma mit einer keilförmigen Grundfläche wäre dann mit seinen vier Ecken in dem Außenring gelagert. Eine Rotation des ersten optischen Elements kann beispielsweise durch Einblasen von Druckluft in den Außenring realisiert werden. Es kann beispielsweise aber auch vorgesehen sein, dass das erste optische Element fest in dem Außenring eingespannt ist und der Außenring selbst dann mittels der Wirkverbindung 37 angetrieben wird. Beispielsweise kann der Außenring von einem endlosen Kraftübertragungselement umschlungen sein, beispielsweise einem Riemen, und mittels des Motors 38 angetrieben werden. Es kann auch direkt ein Rad mit entsprechend haftender Oberfläche, beispielsweise einer Gummierung, an den Außenring angelegt und durch den Motor 38 angetrieben sein.

Der Begriff "Prisma mit keilförmiger Grundfläche" ist hinsichtlich der optischen Wirkung eines diesbezüglich ausgestalteten optischen Elements 100 auf dem Beleuchtungs-Lichtstrahl 22 zu verstehen. Das bedeutet keinesfalls, dass das erste optische Element 100 bei einer Ausgestaltung als Prisma mit keilförmiger Grundfläche in einem Querschnitt senkrecht zu der Grundfläche zwingend viereckig ausgestaltet sein muss. Es kann in einem Querschnitt senkrecht zu der Grundfläche auch kreisförmig ausgestaltet sein, so dass es vollflächig den Außenring 102 ausfüllt.

Insgesamt kommt es bei der Bewegung des ersten optischen Elements 100 darauf an, dass sich dabei die regelmäßigen Strukturen des Retroreflektors 30 und ein ggf. darauf anhaftender Schmutz als Bewegungsunschärfe verwischen.

Für die retroreflektierende Beschichtung 32 des Retroreflektors 30 wird vorzugsweise ein gleichmäßiges Muster von Einzelelementen verwendet, z.B. regelmäßig angeordnete Tripelprismen oder Tripelspiegel. Dann kann es sinnvoll sein, die Bewegung des ersten optische Element 100 mit Vertikal-Synchronimpulsen der Kamera 36 zu verkoppeln.

Hierzu wird die in Fig. 1 dargestellte Beschaltung eingesetzt. Die Beschaltung besteht aus einem elektronischen Steuergerät 40, das über eine erste Leitung 41 an die Kamera 36 und über eine zweite Leitung 42 an den Antriebsmotor 38 angeschlossen ist. Das elektronische Steuergerät 40 gibt seinerseits über eine dritte Leitung 43 Steuerbefehle an den Antriebsmotor 38 ab.

Über die erste Leitung 41 werden die vertikalen Synchronimpulse der Kamera 36 zum elektronischen Steuergerät 40 übertragen. Der Motor 38 liefert über die zweite Leitung 42 Encoderimpulse, die im elektronischen Steuergerät 40 mit den vertikalen Synchronimpulsen verglichen werden. Aus diesem Vergleich wird ein Steuersignal für den Strom oder die Spannung des Antriebsmotors 38 abgeleitet, das über die dritte Leitung 43 übertragen wird. Die Regelung kann dabei eine Drehzahlsynchronisierung bewirken, das heißt, dass die Drehzahl des Antriebsmotors 38 an die Frequenz der vertikalen Synchronimpulse angepasst wird. Besonders bevorzugt ist jedoch darüber hinaus eine phasenstarre Kopplung, so dass auch eine vorbestimmte Phasenlage zwischen der periodischen Bewegung des Antriebsmotors 38 (beispielsweise der Drehbewegung) und den vertikalen Synchronimpulsen der Kamera 36 sichergestellt ist.

Durch die Verwendung eines bewegten ersten optischen Elements 100 wird erreicht, dass aufgrund der zeitlich variierenden Ausbreitung des Beleuchtungs-Lichtstrahls eine virtuelle Bewegung des Retroreflektors erfasst wird. Damit erscheint der Hintergrund, vor dem das Brillenglas 16 in der Kamera 36 abgebildet wird, homogen. Man vermeidet daher den Nachteil bekannter Anordnungen, bei denen dem zu erkennenden Signierzeichen noch eine andere unscharfe Struktur überlagert ist, die sogar die Größenordnung des zu erkennenden Signierzeichens haben kann. Wenn man hingegen das erste optische Element 100 und damit den Beleuchtungs-Lichtstrahl 22 relativ zu dem in der dargestellten Ausführungsform feststehenden Retroreflektor 30 in der beschriebenen Weise bewegt, kann man bei der Bildverarbeitung ein homogenes Grundbild abziehen. Dies ist bei bekannten Vorrichtungen häufig schon deswegen nicht möglich, weil das inhomogene Hintergrundmuster bei unterschiedlich gewölbten Brillengläsern in unterschiedlicher Größe abgebildet wird. Des Weiteren wird aufgrund der Bewegung des ersten optischen Elements 100 vermieden, dass Teile des Beleuchtungs-Lichtstrahls 22 verwischt und andere Teile nicht oder nur sehr wenig verwischt werden, wie dies bei bekannten Anordnungen mit rotierendem Retroreflektor 30 der Fall ist.

Besonders vorteilhaft ist es bei der Beobachtung des kontrastierten Bildes, wenn man das Videosignal der Kamera 36 zusätzlich über eine Kontrastierungseinrichtung laufen lässt. Diese führt z.B. eine lokale Faltungsoperation auf den Grauwerten mit einer Kernfunktion aus, die in mehrere Richtungen differenzierenden Charakter hat. Man berechnet damit für jedes Pixel P[ij], wobei i die Zeile und j die Spalte des Pixels angibt, die Summe

$$A[i,j] = c * \sum_{ii,jj=1..n} P[i-ii, j-jj] * K[ii, jj]$$

und zeigt die Anzeigewerte A[i, j] an oder man verarbeitet diese z.B. in einer Mustererkennung weiter. Dabei ist n die Kernlänge (z.B. n = 3) und c ist ein geeigneter Normierungsfaktor. Ein geeigneter Faltungskern ist z.B.:

$$K[ii, jj] = \begin{pmatrix} -1 & 0 & -1 \\ 0 & 4 & 0 \\ -1 & 0 & -1 \end{pmatrix}$$

oder

$$K[ii, jj] = \begin{pmatrix} 0 & -1 & 0 \\ -1 & 4 & -1 \\ 0 & -1 & 0 \end{pmatrix}$$

oder

$$K[ii, jj] = \begin{pmatrix} -1 & -1 & -1 \\ -1 & 8 & -1 \\ -1 & -1 & -1 \end{pmatrix}$$

Die Kontrastierungsfunktion kann man beispielsweise mit einem Universalrechner fortlaufend berechnen und das (an den Rändern des Bildbereichs jeweils um eine Kernlänge verkürzte) Bild anzeigen. Es ist sogar leicht möglich, eine solche Kontrastierung ohne einen Rechner in Hardware zu implementieren und das Ergebnis in Echtzeit auf einem Video-Bildschirm anzuzeigen. Hierzu benötigt man einen Videodigitalisierer und so viele Verzögerungsleitungen, wie der Faltungskern Zeilen hat (in der obigen Notation also n) und einen sog. Convolver-Chip, wie er beispielsweise kommerziell von der Firma Plessey unter der Bezeichnung PDSP 16488 erhältlich ist.

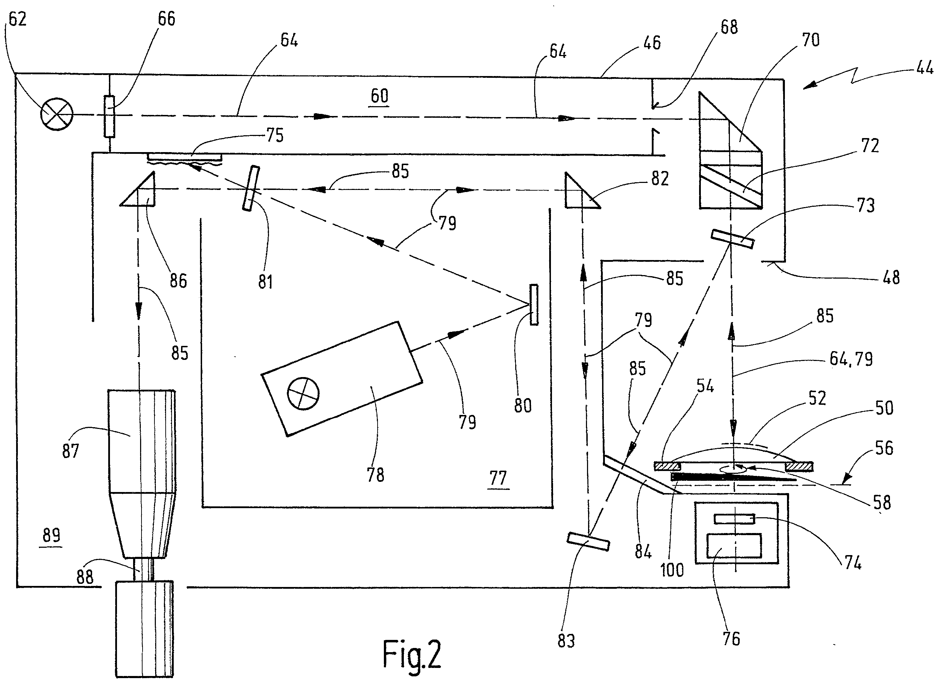

Beim Ausführungsbeispiel gemäß Fig. 2 bezeichnet 44 eine Vorrichtung, nämlich ein Scheitelbrechwert-Messgerät, mit einem lichtdichten Gehäuse 46.

In Fig. 2 ist nur ein Signierzeichen 52 abgebildet. In der Realität sind jedoch zwei Signierzeichen vorgesehen, die sich im vorgegebenen Abstand oberhalb bzw. unterhalb der Zeichenebene befinden. Diese beiden Signierzeichen definieren mit ihrer Lage diejenige Stelle eines Brillenglases 50, an der eine physikalische Eigenschaft, z.B. die Brechkraft des Brillenglases 50, gemessen werden soll. Auf diese Stelle wird ein Mess-Lichtstrahl 64 gerichtet. Zu diesem Zweck wird das Brillenglas 50 von einem Bediener auf eine Auflage 54 aufgelegt und dort relativ zu den Signierzeichen 52 manuell ausgerichtet. Es kann sich dabei um ein handelsübliches Scheitelbrechwert-Messgerät handeln. Bei diesem wird das Brillenglas 50 bei der Messung so positioniert, dass die kontrastiert angezeigten Signierzeichen 52 im Kamerabild an einer vorgegebenen Stelle liegen. Die Signierzeichen 52 liegen somit nicht an der Messstelle selbst, sondern in einer bestimmten geometrischen Relation dazu.

Das Gehäuse 46 weist lediglich auf der in Fig. 2 rechten Seite eine von außen zugängliche Aussparung 48 auf. In dieser Aussparung 48 befindet sich eine Aufnahme für das Brillenglas 50, das mit den Signierzeichen 52 versehen ist.

Unterhalb des Brillenglases 50 befindet sich ein hier nur schematisch angedeuteter Retroreflektor 56, der mittels (nicht dargestellter) Antriebsmittel drehbar ist, wie mit einem Pfeil 58 angedeutet. Insofern gilt das Gleiche, was weiter oben zum Ausführungsbeispiel gemäß Fig. 1 erläutert wurde.

Im Gehäuse 46 befindet sich eine obere Kammer 60, an deren linkem Ende eine Mess-Lichtquelle 62 angeordnet ist. Die Mess-Lichtquelle 62 sendet einen Mess-Lichtstrahl 64 aus. Dieser läuft zunächst durch ein erstes Farbfilter 66 und dann durch eine Blende 68, ehe er in einem Prisma 70 oder einem entsprechenden Spiegel nach unten umgelenkt wird. Der Mess-Lichtstrahl 64 läuft dann durch einen Prismenkompensator 72 sowie durch ein Loch in einem durchbohrten Spiegel 73 und trifft dann auf die Oberseite des Brillenglases 50 auf. Er durchläuft das Brillenglas 50 sowie das erste optische Element 100 und durchsetzt dann ein in bevorzugter Weiterbildung der Erfindung vorgesehenes zweites Farbfilter 74, ehe er auf einen Sensor 76 trifft.

Alternativ kann auch durch eine geeignete optische Führung des Mess-Lichtstrahls 64 vorgesehen sein, dass dieser das erste optische Element 100 nicht durchläuft, damit dieses die Messung nicht beeinflusst. Ansonsten ist die Auswertung der Messung basierend auf bekannten optischen Eigenschaften des ersten optischen Elements 100 auszuwerten. Als weitere Alternative kann auch vorgesehen sein, das erste optische Element als Spiegel auszubilden.

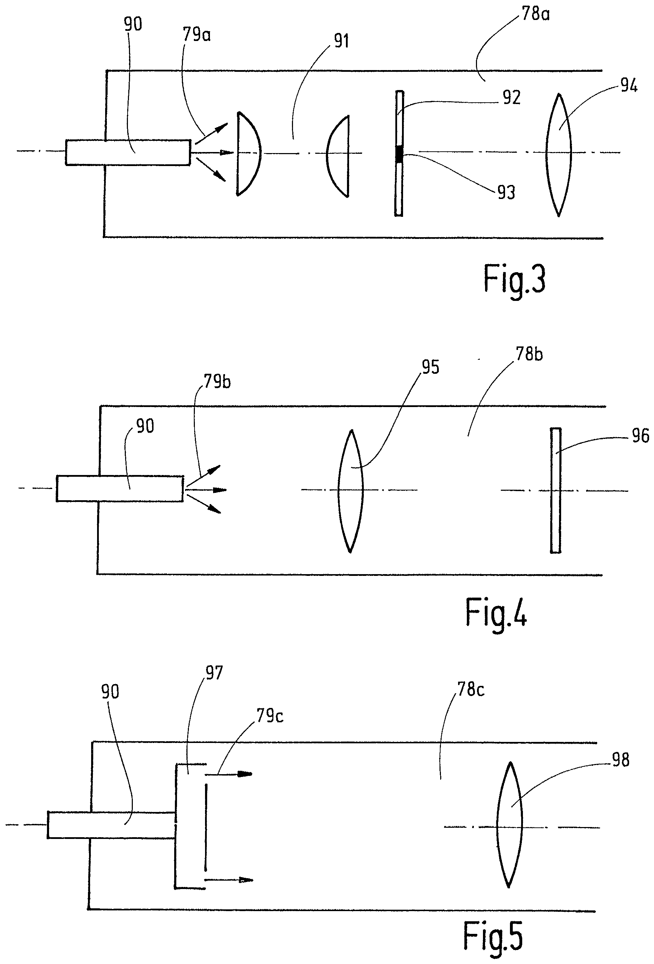

In einer zentralen Kammer 77 des Gehäuses 46 befindet sich eine Beleuchtungs-Lichtquelle 78, von der drei Ausführungsbeispiele weiter unten an Hand der Fig. 3 bis 5 noch erläutert werden.

Die Beleuchtungs-Lichtquelle 78 sendet einen Beleuchtungs-Lichtstrahl 79 aus. Dieser gelangt zunächst auf einen Umlenkspiegel 80 und dann auf einen als Strahlenteiler 81 wirkenden halbdurchlässigen Spiegel. Ein durch den Strahlenteiler 81 hindurchtretender Anteil des Beleuchtungs-Lichtstrahls 79 wird in einer Lichtfalle 75 absorbiert, die hinter dem Strahlenteiler 81 angeordnet ist. Der Beleuchtungs-Lichtstrahl 79 wird im Wesentlichen jedoch von dem Strahlenteiler 81 nach rechts umgelenkt, um dann auf ein Prisma 82 oder einen Spiegel zu treffen, der den Beleuchtungs-Lichtstrahl 79 nach unten umlenkt. Nach erneuter Umlenkung durch einen Umlenkspiegel 83 läuft der Beleuchtungs-Lichtstrahl 79 durch ein Fenster 84 der Aussparung 48 und trifft auf den durchbohrten Spiegel 73, der den Beleuchtungs-Lichtstrahl 79 wiederum nach unten umlenkt, wo er auf das Brillenglas 50 trifft und das Signierzeichen 52 beleuchtet.

Der vom Brillenglas 50 bzw. dem Signierzeichen 52 reflektierte Beleuchtungs-Lichtstrahl 79 bildet nun einen Beobachtungs-Lichtstrahl 85, der zunächst nach oben verläuft und dann über den durchbohrten Spiegel 73, den Umlenkspiegel 83, das Prisma 82 und den Strahlenteiler 81 auf ein weiteres Prisma 86 oder einen entsprechenden Spiegel gelangt, der den Beobachtungs-Lichtstrahl 85 nach unten umlenkt, wo er über ein Objektiv 87 zu einer CCD-Kamera 88 gelangt. Das Prisma 86, das Objektiv 87 und die CCD-Kamera 88 befinden sich in einer linken Kammer 89 des Gehäuses 46.

Die Eintrittspupille des Objektivs 87 und die Austrittspupille der Beleuchtungs-Lichtquelle 78 sind bezüglich des Strahlenteilers 81 zueinander konjugiert.

Die Vorrichtung 44 gemäß Fig. 2 arbeitet wie folgt: In einem Messzweig wird der Mess-Lichtstrahl 64 von der Mess-Lichtquelle 62 in der beschriebenen Weise auf das Brillenglas 50 eingestrahlt, durchsetzt dieses und gelangt auf den Sensor 76. Auf diese Weise können physikalische Eigenschaften des Brillenglases gemessen werden. Zur besseren Unterscheidung vom Beleuchtungs-Lichtstrahl 79 bzw. vom Beobachtungs-Lichtstrahl 85 wird der Mess-Lichtstrahl 64 mit einer anderen Lichtwellenlänge ausgestrahlt, beispielsweise als grünes Licht. Hierzu ist das erste Farbfilter 66 als Grünfilter ausgestaltet. Das zweite Farbfilter 74 vor dem Sensor 76 hat demgegenüber die Funktion eines Sperrfilters, das andere Lichtwellenlängen, insbesondere die der Beleuchtungs-Lichtquelle 78, nicht durchlässt. Auf diese Weise wird verhindert, dass anderes Licht außer dem Mess-Lichtstrahl 64 auf den Sensor 76 gelangt.

Gleichzeitig wird über die Beleuchtungs-Lichtquelle 78 der Beleuchtungs-Lichtstrahl 79 in der beschriebenen Weise auf das Brillenglas 50 gerichtet, um dort das Signierzeichen 52 zu beleuchten. Das reflektierte Bild des Signierzeichens 52 gelangt dann als Beobachtungs-Lichtstrahl 85 zur CCD-Kamera 88 und wird von dort als Videosignal ausgewertet.

Während dies geschieht, wird das erste optische Element 100 unterhalb des Brillenglases 50 bewegt (Pfeil 58) und zwar in der beschriebenen Weise. Die Frequenz einer der vorgenannten periodischen Bewegungen des Retroreflektors 56 wird dabei wiederum so gewählt, dass sie an eine Auslesefrequenz der Kamera 88 angepasst ist. Auch hier versteht sich, dass eine weitere Kontrastierung durch Faltungsoperationen der oben erläuterten Art bewirkt werden kann.

Über die Auswertung des Videosignales der CCD-Kamera 88 kann alternativ oder zusätzlich zum Sensor 76 auch eine Messung eines physikalischen Parameters des Brillenglases 50 vorgenommen werden.

Im Allgemeinen wird jedoch angestrebt, den Messzweig einerseits und den Beleuchtungs-/Beobachtungszweig andererseits voneinander zu entkoppeln.

Hierzu ist die Beleuchtungs-Lichtquelle 78 vorzugsweise so ausgebildet, wie dies in drei Ausführungsbeispielen in den Fig. 3 bis 5 dargestellt ist.

Allen drei Ausführungsbeispielen gemäß den Fig. 3 bis 5 ist gemein, dass das Licht über einen Lichtleiter 90 zugeführt wird. Selbstverständlich schließt dies nicht aus, dass das Licht statt dessen auch in der Beleuchtungs-Lichtquelle 78 selbst erzeugt werden kann, beispielsweise durch einen Laser, eine Laserdiode, eine LED oder dgl. mehr.

Beim Ausführungsbeispiel gemäß Fig. 3 strahlt in der Beleuchtungs-Lichtquelle 78a der Lichtleiter 90 den Beleuchtungs-Lichtstrahl 79a aus, der an dieser Stelle ein divergierender Lichtstrahl ist. Mittels einer nachgeordneten Kollimationsoptik 91 wird der Beleuchtungs-Lichtstrahl 79a parallelisiert und gelangt nun auf ein transparentes Dia 92, das lediglich im Bereich der optischen Achse einen zentralen schwarzen Fleck 93 aufweist. Über eine Abbildungsoptik 94 wird der Beleuchtungs-Lichtstrahl 79a nun auf den Umlenkspiegel 80 (Fig. 2) gerichtet.

Durch die Abbildung des zentralen schwarzen Flecks 93 auf der Oberfläche des Brillenglases 50 wird erreicht, dass in die zur optischen Messung verwendete Öffnung der rohrförmigen Auflage 54 kein Beleuchtungs-Licht eindringt. Dies ist genau der Bereich, in dem der Mess-Lichtstrahl 64 auf das Brillenglas 50 auftrifft. Auf diese Weise wird also verhindert, dass Beleuchtungs-Licht durch das Brillenglas 50 hindurch auf den Sensor 76 fällt.

Wie bereits erwähnt wurde, kann vor dem Sensor 76 noch das zweite Farbfilter 74 vorgesehen sein, das für die Lichtwellenlänge des Beleuchtungs-Lichtes als Sperrfilter wirkt. Wenn das Mess-Licht beispielsweise grünes Licht ist, so kann das Beleuchtungs-Licht vorzugsweise rotes Licht sein.

Beim zweiten Ausführungsbeispiel gemäß Fig. 4 weist die Beleuchtungs-Lichtquelle 78b hinter dem Austritt des Lichtleiters 90 ebenfalls eine Kollimationsoptik 95 für den divergierenden Beleuchtungs-Lichtstrahl 79b auf. In diesem Falle ist der Kollimationsoptik 95 ein Farbfilter 96 vorgeschaltet, das beispielsweise in der vorstehend beschriebenen Weise ein Rotfilter sein kann.

Beim dritten Ausführungsbeispiel gemäß Fig. 5 ist schließlich in der Beleuchtungs-Lichtquelle 78c am freien Ende des Lichtleiters 90 ein Ring-Austritt 97 vorgesehen, der einen im Querschnitt ringförmigen Beleuchtungs-Lichtstrahl 79c erzeugt. Dieser wird über eine Abbildungsoptik 98 auf den Umlenkspiegel 80 gerichtet.

Auch hier entsteht, ähnlich wie beim Ausführungsbeispiel gemäß Fig. 3, ein zentraler abgeschatteter Bereich, in dem kein Beleuchtungs-Licht auf die Oberfläche des Brillenglases 50 fällt und in dem das Mess-Licht durch das Brillenglas 50 auf den Sensor 76 geleitet werden kann.

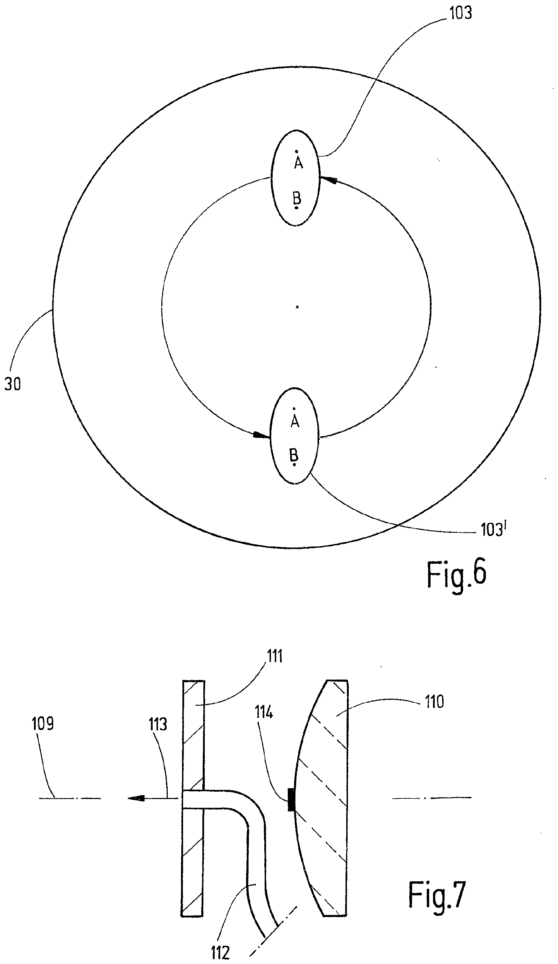

In Fig. 6 ist schematisch die in dem Ausführungsbeispiel der Fig. 1 erzeugte scheinbare Bewegung eines Reflexionsbereichs 103 auf dem Retroreflektor 30 dargestellt, wenn die optische Wirkung der Linse 16 außer Betracht gelassen wird. Dann hat der Beleuchtungs-Lichtstrahl 22 vor dem Durchlaufen des ersten optischen Elements 100 z.B. einen kreisförmigen Querschnitt. Durch seine seitliche Ablenkung bzw. dadurch, dass die reflektierende Oberfläche des Retroreflektors 30 den Beleuchtungs-Lichtstrahl 22 durchschneidet, ergibt sich auf der reflektierenden Oberfläche des Retroreflektors 30 ein ellipsenförmiger Reflexionsbereich 103, wie dies in Fig. 6 angedeutet ist. Eine Rotation des ersten optischen Elements 100 um 180° variiert den Reflexionsbereich 103, so dass er dann eine mit dem Bezugszeichen 103' angedeutete Lage einnimmt. Durch die Rotation des ersten optischen Elements, das als Prisma mit kreisförmiger Grundfläche ausgebildet ist und um eine Achse rotiert wird, die senkrecht auf der reflektierenden Oberfläche des Retroreflektors 30 steht, beschreibt der Reflexionsbereich 103 eine kreisförmige Bahn. Dabei bleibt eine Orientierung des Reflexionsbereichs 103 jedoch erhalten, wie dies durch die Lage der Punkte A und B in den Reflexionsbereichen 103 und 103' dargestellt ist. Bei einem Betrachten des Retroreflektors 30 durch das rotierende erste optische Element entsteht daher der Eindruck, dass der Retroreflektor 30 eine parallele Drehtranslationsbewegung beschreibt. Auf diese Weise wird mit relativ einfachem apparativem Aufbau eine "virtuelle Bewegung" des Retroreflektors 30 erreicht, die, wollte man den Retroreflektor 30 selbst bewegen, nur mit höherem mechanischem Aufwand umzusetzen und auszuwuchten ist.

Fig. 7 zeigt schließlich noch eine Variante, bei der ohne Strahlenteiler (vgl. 24 in Fig. 1 bzw. 81 in Fig.

2) gearbeitet wird.

Zu diesem Zweck wird die Beleuchtungsquelle zentral vor dem Kameraobjektiv angeordnet. In dem dargestellten Beispiel ist quer zur Achse 109 vor dem Kameraobjektiv 110 eine planparallele Glasplatte 111 angeordnet, die zentrisch das Ende einer Lichtleitfaser 112 trägt. Aus der Lichtleitfaser 112 tritt der Beleuchtungs-Lichtstrahl 113 aus. Um zu vermeiden, dass Licht direkt in die Kamera zurückfällt, wird ein kleiner Bereich 114 auf dem Kameraobjektiv 110 geschwärzt.

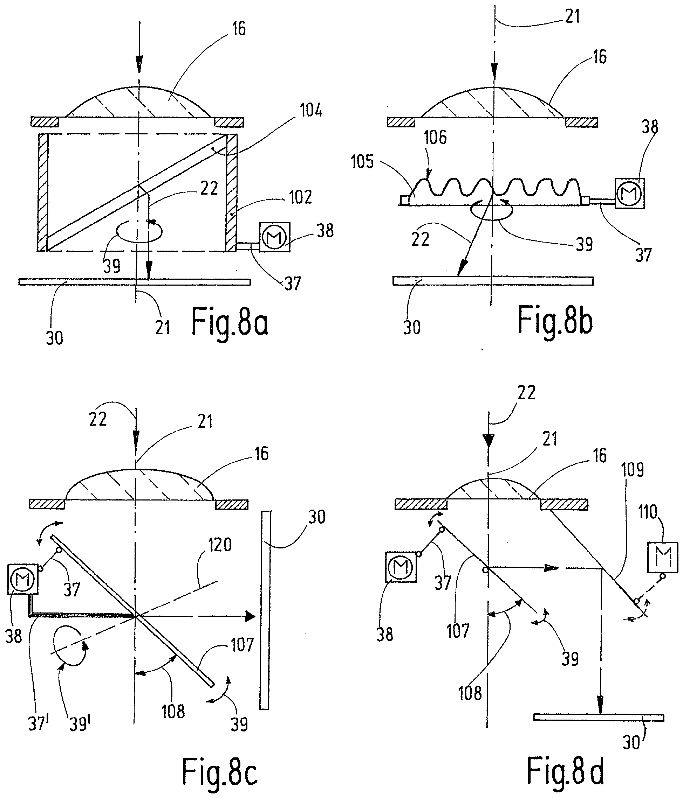

In der Fig. 8 sind schematische Ausführungsformen des ersten optischen Elements 100 dargestellt, die alternativ zu seiner Ausgestaltung als Prisma mit keilförmiger Grundfläche verwendet werden können. Gleiche Elemente sind mit gleichen Bezugszeichen gekennzeichnet und werden im Folgenden nicht näher erläutert. Es ist lediglich der relevante Ausschnitt zwischen dem Brillenglas 16 und dem Retroreflektor 30 dargestellt und beschrieben.

Fig. 8a zeigt eine Ausgestaltung des ersten optischen Elements als zu der optischen Achse 21 verkippte planparallele Platte 104. Die planparallele Platte 104 erzeugt einen Parallelversatz des Beleuchtungs-Lichtstrahls 22. Durch eine entsprechende Lagerung der planparallelen Platte 104 in einem Außenring 102 kann eine rotierende Bewegung 39 der planparallelen Platte 104 bewirkt werden. Auf diese Weise lässt sich ebenfalls eine kreisförmige Bewegung des Reflexionsbereichs 103 auf dem Retroreflektor 30 erzeugen.

In Fig. 8b ist als erstes optisches Element eine Platte 105 mit einer wellenförmigen Oberfläche 106 dargestellt. Dabei ist darauf zu achten, dass die Oberfläche 106 nicht senkrecht auf der optischen Achse 21 bzw. der Rotationsachse der Platte 105 steht, die in diesem Fall zusammenfallen. Auch die wellenförmige Oberfläche 106 erzeugt eine Ablenkung des einfallenden Lichtstrahls 22. Durch Rotation der Platte 105 wird ein Reflexionsbereich auf dem Retroreflektor 30 wiederum kreisförmig variiert, auch wenn in der Regel keine scharfe Abgrenzung des Reflexionsbereichs 103 auf dem Retroreflektor 30 zu erkennen ist, wie dies in der Fig. 6 erläutert ist. Auch auf diese Weise kann ein ausreichender Verwischungseffekt erzielt werden.

In Fig. 8c ist das erste optische Element als ein Spiegel 107 ausgebildet. In der dargestellten Ausführungsform ist der Retroreflektor 30 im Vergleich zu den übrigen Ausführungsformen um 90° verkippt. Die reflektierende Oberfläche des Retroreflektors 30 verläuft parallel zu der optischen Asche 21.

In der Fig. 8c sind zwei verschiedene mögliche Arten zur Bewegung des Spiegels 107 dargestellt. Zunächst ist es möglich, ein Einfallswinkel 108 des Beleuchtungs-Lichtstrahls 22 durch ein Verkippen des Spiegels 107 relativ zu dem einfallenden Beleuchtungs-Lichtstrahl zu variieren. In diesem Fall wird der Reflexionsbereich 103 des Beleuchtungs-Lichtstrahls 22 auf dem Retroreflektor 30 linear variiert. Der Spiegel 107 wird oszillierend verkippt, wie durch ein Pfeil 39 angedeutet ist.

Des Weiteren kann vorgesehen sein, dass der Spiegel 107 mit einer Wirkverbindung 37' taumelnd rotiert wird. In diesem Fall steht eine Rotationsachse 120 schräg auf einer spiegelnden Oberfläche des Spiegels 107. Die Darstellung mittels der Wirkverbindung 37' ist lediglich beispielhaft zu verstehen. Der Motor kann dann alternativ auch auf der Rotationsachse 120 angeordnet sein, wobei seine Abtriebswelle unter einem Winkel ungleich 90° an dem Spiegel 107 montiert ist. Auch eine taumelnde Rotation des Spiegels 107, wie sie durch den Pfeil 99' angedeutet ist, führt einen ausreichenden Verwischungseffekt herbei. Lediglich zu Darstellungszwecken ist ein Winkel zwischen der Rotationsachse 120 und der spiegelnden Oberfläche des Spiegels 107 stark von 90° abweichend dargestellt. Bereits kleine Abweichungen können ausreichend sein.

In der Fig. 8d ist eine weitere Ausführungsform vorgesehen, bei der das erste optische Element wiederum als Spiegel 107 ausgebildet ist, der oszillierend verkippt wird, wie dies voranstehend beschrieben wurde. Des Weiteren ist jedoch ein zweiter Spiegel 109 vorgesehen, der den einfallenden Beleuchtungs-Lichtstrahl 22 reflektiert, etwa um 90°. Der Retroreflektor 30 bzw. dessen reflektierende Oberfläche kann dann wiederum senkrecht zu der optischen Achse 21 des Brillenglases 16 angeordnet werden.

Des Weiteren kann auch der zweite Spiegel 109 mit einem Antriebsmotor 110 versehen und um eine Achse kippbar sein, die jedoch nicht parallel zu der des ersten Spiegels liegt. Durch das Zusammenwirken beider Reflexionen beschreibt der Beleuchtungs-Lichtstrahl 22 auf dem Retroreflektor 30 dann eine Figur, z.B. eine Kreisbahn.

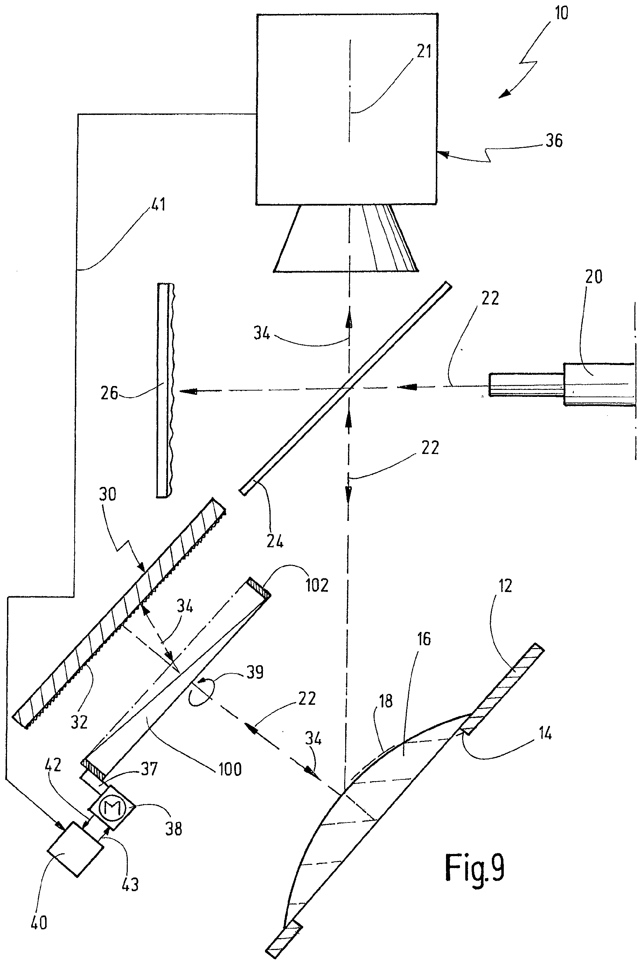

Fig. 9 zeigt eine äußerst schematisierte Seitenansicht eines zweiten Ausführungsbeispiels einer erfindungsgemäßen Vorrichtung.

Selbstverständlich können die voranstehend genannten Ausführungsformen auch so variiert werden, dass sie geeignet sind, Signierzeichen auf einem Brillenglas kontrastreich darzustellen, jedoch nicht, wie voranstehend geschildert in Transmission, sondern in Reflexion. Die Fig. 9 zeigt einen möglichen reflektierenden Aufbau. Gleiche Elemente sind dabei mit gleichen Bezugszeichen bezeichnet und werden nicht erneut erläutert.

Die zu prüfende Linse 16 wird in diesem Fall unter einem Winkel zur seiner optischen Achse beobachtet. Der von der Linse 16 reflektierte Beleuchtungs-Lichtstrahl 22 trifft nach der Linse auf den Retroreflektor 30, der mit Hilfe des optischen Elements 100 virtuell in seiner Aufstellungsebene bewegten wird. Der Retroreflektor leitet in der reflektierenden Anordnung den Beleuchtungs-Lichtstrahl 22 mit einem kleinen Strahlversatz (der Übersicht halber nicht dargestellt) zurück auf die Linse 16, wo es ein erneut reflektiert wird und schließlich zu der Kamera 16 zurückgelangt. Die Effekte sind auch in dieser Variation die gleichen, wie für den Fall einer transmittiven Anordnung in den Figuren 1 bis 8 ausführlich besprochen.

Um bei einer derartigen reflektiven Anordnung die Ebene der Linse 16 gleichmäßig scharf abzubilden, kann es sinnvoll sein, die Schärfenebene durch eine Scheimpflug-Anordnung schräg der optischen Achse 21 des Beobachtungsobjektivs anzuordnen. Eine Anwendungsfall für eine reflektierende Anordnung ist beispielsweise gegeben, wenn die Linse 16 noch in einem Zustand ist, bei dem die der Kamera 36 abgewandte Seite der Linse 16 nicht durchsichtig ist.

**Patentansprüche**

1. Verfahren zum Sichtbarmachen eines Signierzeichens (18; 52) auf einem Brillenglas (16; 50), bei dem ein Beleuchtungs-Lichtstrahl (22; 79) auf das Brillenglas (16; 50) gerichtet wird, der auf das Brillenglas (16; 50) trifft, nach dem Auftreffen auf das Brillenglases (16; 50) an einem als Retroreflektor ausgebildeten Reflektor (30; 56) reflektiert wird, als Beobachtungs-Lichtstrahl (34; 85) erneut auf das Brillenglas (16; 50) trifft, und schließlich einer Kamera (36; 88) zugeleitet wird, **dadurch gekennzeichnet, dass** der Reflektor (30; 56) feststeht, und dass ein Reflexionsbereich (103) des Beleuchtungs-Lichtstrahls (22; 79) auf dem Reflektor (30; 56) mittels eines bewegten (39; 58) ersten optischen Elements (100; 104; 105; 107) variiert wird, wobei der Beleuchtungs-Lichtstrahl (22; 79) nach dem Brillenglas (16; 50) auf das erste optische Element (100; 104; 105; 107) trifft.

2. Verfahren nach Anspruch 1, **dadurch gekennzeichnet, dass** der Reflexionsbereich (103) des Beleuchtungs-Lichtstrahls (22; 79) auf dem Reflektor (30; 56) linear bewegt wird.

3. Verfahren nach Anspruch 2, **dadurch gekennzeichnet, dass** ein Einfallswinkel (108) des Beleuchtungs-Lichtstrahls (22; 79) auf das erste optische Element (100; 104; 105; 107) variiert wird, wobei das erste optische Element (100; 104; 105; 107) relativ zu dem Beleuchtungs-Lichtstrahl (22; 79) oszillierend verkippt wird.

4. Verfahren nach einem der Ansprüche 1 bis 3, **dadurch gekennzeichnet, dass** der Reflexionsbereich (103) des Beleuchtungs-Lichtstrahls (22; 79) auf dem Reflektor (30; 56) kreisförmig oder ellipsenförmig bewegt wird.

5. Verfahren nach Anspruch 4, **dadurch gekennzeichnet, dass** das erste optische Element (100; 104; 105; 107) um eine im Wesentlichen parallel zu einer optischen Achse (21) des Brillenglases (16; 50) verlaufende Achse rotiert wird.

**6.** Verfahren nach einem der Ansprüche 1 bis 5, **dadurch gekennzeichnet, dass** das erste optische Element (100; 104; 105; 107) eine zu einer optischen Achse (21) des Brillenglases (16; 50) verkippte planparallele Platte (104), ein Prisma mit keilförmiger Grundfläche (100) oder eine Platte (105) mit mindestens einer wellenförmigen Oberfläche (106) ist.

**7.** Verfahren nach einem der Ansprüche 1 bis 3, **dadurch gekennzeichnet, dass** das erste optische Element ein Spiegel (107) ist, insbesondere wobei der Spiegel (107) taumelnd (39') rotiert wird.

**8.** Vorrichtung konfiguriert zum Sichtbarmachen eines Signierzeichens (18; 52) auf einem Brillenglas (16; 50), mit

- einer auf einer ersten Seite des Brillenglases (16; 50) angeordneten Beleuchtungs-Lichtquelle (20; 78) zum Erzeugen eines Beleuchtungs-Lichtstrahles (22; 79), für eine Erkennung des Signierzeichens (18; 52);
- einem auf der der ersten Seite gegenüberliegenden Seite des Brillenglases (16; 50) angeordneten, als Retroreflektor ausgebildeten Reflektor (30; 56);
- einer Kamera (36; 87) zum Empfangen eines von dem Brillenglas (16; 50) kommenden Beobachtungs-Lichtstrahles (34; 85);

**dadurch gekennzeichnet, dass** der Reflektor (30; 56) feststehend ausgebildet ist, und dass die Vorrichtung des Weiteren ein erstes optisches Element (100; 104; 105; 107) zum Variieren eines Reflexionsbereichs (103) des Beleuchtungs-Lichtstrahls (22; 79) auf dem Reflektor (30; 56) aufweist, wobei das erste optische Element (100; 104; 105; 107) bewegbar gelagert ist, und wobei das erste optische Element (100; 104; 105; 107) in einem Strahlengang des Beleuchtungs-Lichtstrahls (22; 79) nach dem Brillenglas (16; 50) angeordnet ist.

**9.** Vorrichtung nach Anspruch 8, **dadurch gekennzeichnet, dass** die Vorrichtung (10; 44) eine Antriebseinrichtung (38) aufweist, die derart mit dem ersten optischen Element (100; 104; 105; 107) gekoppelt ist, dass sie das erste optische Element (100; 104; 105; 107) relativ zu dem Beleuchtungs-Lichtstrahl (22; 79) oszillierend verkippt, um einen Einfallswinkel (108) des Beleuchtungs-Lichtstrahls (22; 79) auf das erste optische Element (100; 104; 105; 107) zu variieren.

**10.** Vorrichtung nach einem der Ansprüche 8 bis 9, **dadurch gekennzeichnet, dass** die Vorrichtung (10; 44) eine Antriebseinrichtung (38) aufweist, die derart mit dem ersten optischen Element (100; 104; 105; 107) gekoppelt ist, dass sie das erste optische Element (100; 104; 105; 107) um eine im Wesentlichen parallel zu einer optischen Achse (21) des Brillenglases (16; 50) verlaufende Achse rotiert.

**11.** Vorrichtung nach einem der Ansprüche 8 bis 10, **dadurch gekennzeichnet, dass** das erste optische Element eine zu einer optischen Achse (21) des Brillenglases (16; 50) verkippte planparallele Platte (104), ein Prisma mit keilförmiger Grundfläche (100), eine Platte (105) mit mindestens einer wellenförmigen Oberfläche (106) oder ein Spiegel (107) ist, insbesondere wobei die Vorrichtung des Weiteren eine Antriebseinrichtung (38) aufweist, die derart mit dem Spiegel (107) gekoppelt ist, dass sie den Spiegel (107) taumelnd rotiert.

**12.** Vorrichtung nach einem der Ansprüche 8 bis 11, **dadurch gekennzeichnet, dass** die Vorrichtung (10; 44) des Weiteren mindestens ein optisches Führungselement (24; 73, 80, 81, 82, 83, 85, 86) zum Führen des Beleuchtungs-Lichtstrahles (22; 79) durch das Brillenglas (16; 50) hindurch und/oder zum Führen des von dem Reflektor (30; 56) durch das Brillenglas (16; 50) hindurch reflektierten Beobachtungs-Lichtstrahles (34; 85) zu der Kamera (36; 87) aufweist.

**13.** Vorrichtung nach Anspruch 12, **dadurch gekennzeichnet, dass** das optische Führungselement (24; 73, 80, 81, 82, 83, 85, 86) mindestens ein zweites optisches Element (24; 73, 80, 81, 82, 83) zum Führen des Beleuchtungs-Lichtstrahles (22; 79) durch das Brillenglas (16; 50) hindurch; und mindestens ein drittes optisches Element (82, 83, 85, 86) zum Führen des von dem Reflektor (30; 56) durch das Brillenglas (16; 50) hindurch reflektierten Beobachtungs-Lichtstrahles (34; 85) zu der Kamera (36; 87) aufweist.

**Claims**

**1.** Method for visualizing a signature mark (18; 52) on a spectacle lens (16; 50), in which an illumination light beam (22; 79) is directed onto the spectacle lens (16; 50), which impinges on the spectacle lens (16; 50), after impinging on the spectacle lens (16; 50) is reflected at a reflector (30; 56) embodied as a retroreflector, impinges once again as an observation light beam (34; 85) on the spectacle lens (16; 50), and finally is passed to a camera (36; 88), **characterized in that** the reflector (30; 56) is fixed, and **in that** a reflection region (103) of the illumination light beam (22; 79) on the reflector (30; 56) is varied by means of a moved (39; 58) first optical element (100; 104; 105; 107), wherein the illumination light beam (22; 79) impinges on the first optical element (100; 104; 105; 107) downstream of the spectacle

14

lens (16; 50) .

2. Method according to Claim 1, **characterized in that** the reflection region (103) of the illumination light beam (22; 79) on the reflector (30; 56) is moved linearly.

3. Method according to Claim 2, **characterized in that** an angle (108) of incidence of the illumination light beam (22; 79) on the first optical element (100; 104; 105; 107) is varied, wherein the first optical element (100; 104; 105; 107) is tilted in an oscillating fashion relative to the illumination light beam (22; 79).

4. Method according to any of Claims 1 to 3, **characterized in that** the reflection region (103) of the illumination light beam (22; 79) on the reflector (30; 56) is moved circularly or elliptically.

5. Method according to Claim 4, **characterized in that** the first optical element (100; 104; 105; 107) is rotated about an axis running substantially parallel to an optical axis (21) of the spectacle lens (16; 50).

6. Method according to any of Claims 1 to 5, **characterized in that** the first optical element (100; 104; 105; 107) is a plane-parallel plate (104) tilted with respect to an optical axis (21) of the spectacle lens (16; 50), a prism having a wedge-shaped main surface (100) or a plate (105) having at least one undulatory surface (106).

7. Method according to any of Claims 1 to 3, **characterized in that** the first optical element is a mirror (107), in particular wherein the mirror (107) is rotated in a wobbling fashion (39').

8. Apparatus configured for visualizing a signature mark (18; 52) on a spectacle lens (16; 50), comprising

    - an illumination light source (20; 78) arranged on a first side of the spectacle lens (16; 50) and serving for generating an illumination light beam (22; 79), for identifying the signature mark (18; 52);
    - a reflector (30; 56) embodied as a retroreflector and arranged on that side of the spectacle lens (16; 50) which is situated opposite the first side;
    - a camera (36; 87) for receiving an observation light beam (34; 85) coming from the spectacle lens (16; 50);

    **characterized in that** the reflector (30; 56) is embodied in a fixed fashion, and **in that** the apparatus furthermore comprises a first optical element (100; 104; 105; 107) for varying a reflection region (103) of the illumination light beam (22; 79) on the reflector (30; 56), wherein the first optical element (100; 104; 105; 107) is mounted in a movable fashion, and wherein the first optical element (100; 104; 105; 107) is arranged downstream of the spectacle lens (16; 50) in a beam path of the illumination light beam (22; 79) .

9. Apparatus according to Claim 8, **characterized in that** the apparatus (10; 44) comprises a drive device (38), which is coupled to the first optical element (100; 104; 105; 107) in such a way that it tilts the first optical element (100; 104; 105; 107) in an oscillating fashion relative to the illumination light beam (22; 79), in order to vary an angle (108) of incidence of the illumination light beam (22; 79) on the first optical element (100; 104; 105; 107).

10. Apparatus according to any of Claims 8 to 9, **characterized in that** the apparatus (10; 44) comprises a drive device (38), which is coupled to the first optical element (100; 104; 105; 107) in such a way that it rotates the first optical element (100; 104; 105; 107) about an axis running substantially parallel to an optical axis (21) of the spectacle lens (16; 50).

11. Apparatus according to any of Claims 8 to 10, **characterized in that** the first optical element is a plane-parallel plate (104) tilted with respect to an optical axis (21) of the spectacle lens (16; 50), a prism having a wedge-shaped main surface (100), a plate (105) having at least one undulatory surface (106) or a mirror (107), in particular wherein the apparatus furthermore comprises a drive device (38) coupled to the mirror (107) in such a way that it rotates the mirror (107) in a wobbling fashion.

12. Apparatus according to any of Claims 8 to 11, **characterized in that** the apparatus (10; 44) furthermore comprises at least one optical guide element (24; 73; 80, 81, 82, 83, 85, 86) for guiding the illumination light beam (22; 79) through the spectacle lens (16; 50) and/or for guiding the observation light beam (34; 85) reflected by the reflector (30; 56) through the spectacle lens (16; 50) to the camera (36; 87).

13. Apparatus according to Claim 12, **characterized in that** the optical guide element (24; 73, 80, 81, 82, 83, 85, 86) comprises at least one second optical element (24; 73, 80, 81, 82, 83) for guiding the illumination light beam (22; 79) through the spectacle lens (16; 50); and at least one third optical element (82, 83, 85, 86) for guiding the observation light beam (34; 85) reflected by the reflector (30; 56) through the spectacle lens (16; 50) to the camera (36; 87).

**Revendications**

1. Procédé pour visualiser un repère (18 ; 52) sur un verre de lunettes (16 ; 50), dans lequel un rayon lumineux d'éclairage (22 ; 79) est dirigé sur le verre de lunettes (16 ; 50), heurte le verre de lunettes (16 ; 50), est réfléchi sur un réflecteur (30 ; 56) constitué en tant que rétroréflecteur après l'impact sur le verre de lunettes (16 ; 50), heurte de nouveau le verre de lunettes (16 ; 50) en tant que rayon lumineux d'observation (34 ; 85) et est enfin acheminé à une caméra (36 ; 88), **caractérisé en ce que** le réflecteur (30 ; 56) est stationnaire, et **en ce qu'**une zone de réflexion (103) du rayon lumineux d'éclairage (22 ; 79) sur le réflecteur (30 ; 56) est modifiée au moyen d'un premier élément optique (100 ; 104 ; 105 ; 107) déplacé (39 ; 58), le rayon lumineux d'éclairage (22 ; 79) heurtant le premier élément optique (100 ; 104 ; 105 ; 107) après le verre de lunettes (16 ; 50).

2. Procédé selon la revendication 1, **caractérisé en ce que** la zone de réflexion (103) du rayon lumineux d'éclairage (22 ; 79) est déplacée de façon linéaire sur le réflecteur (30 ; 56).

3. Procédé selon la revendication 2, **caractérisé en ce qu'**un angle d'incidence (108) du rayon lumineux d'éclairage (22 ; 79) sur le premier élément optique (100 ; 104 ; 105 ; 107) est modifié, le premier élément optique (100 ; 104 ; 105 ; 107) étant basculé de façon oscillante relativement au rayon lumineux d'éclairage (22 ; 79).

4. Procédé selon l'une des revendications 1 à 3, **caractérisé en ce que** la zone de réflexion (103) du rayon lumineux d'éclairage (22 ; 79) sur le réflecteur (30 ; 56) est déplacée en forme de cercle ou d'ellipse.

5. Procédé selon la revendication 4, **caractérisé en ce que** le premier élément optique (100 ; 104 ; 105 ; 107) est mis en rotation autour d'un axe s'étendant essentiellement parallèlement à un axe optique (21) du verre de lunettes (16 ; 50).

6. Procédé selon l'une des revendications 1 à 5, **caractérisé en ce que** le premier élément optique (100 ; 104 ; 105 ; 107) est une plaque (104) à faces planes et parallèles basculée par rapport à un axe optique (21) du verre de lunettes (16 ; 50), un prisme avec une surface de base (100) en forme de coin ou une plaque (105) avec au moins une surface (106) ondulée.

7. Procédé selon l'une des revendications 1 à 3, **caractérisé en ce que** le premier élément optique est un miroir (107), le miroir (107) étant en particulier mis en rotation avec un mouvement chancelant (39').

8. Dispositif, configuré pour visualiser un repère (18 ; 52) sur un verre de lunettes (16 ; 50), avec

   - une source de lumière d'éclairage (20 ; 78) disposée sur un premier côté du verre de lunettes (16 ; 50) pour la production d'un rayon lumineux d'éclairage (22 ; 79) pour une détection du repère (18 ; 52) ;
   - un réflecteur (30 ; 56) disposé sur le côté du verre de lunettes (16 ; 50) opposé au premier côté et constitué en tant que rétroréflecteur ;
   - une caméra (36 ; 87) pour la réception d'un rayon lumineux d'observation (34 ; 85) en provenance du verre de lunettes (16 ; 50) ;

   **caractérisé en ce que** le réflecteur (30 ; 56) est constitué de façon stationnaire, et **en ce que** le dispositif présente en outre un premier élément optique (100 ; 104 ; 105 ; 107) destiné à modifier une zone de réflexion (103) du rayon lumineux d'éclairage (22 ; 79) sur le réflecteur (30 ; 56), le premier élément optique (100 ; 104 ; 105 ; 107) étant supporté de façon mobile, et le premier élément optique (100 ; 104 ; 105 ; 107) étant disposé sur un trajet de rayon du rayon lumineux d'éclairage (22 ; 79) après le verre de lunettes (16 ; 50) .

9. Dispositif selon la revendication 8, **caractérisé en ce que** le dispositif (10 ; 44) présente un système d'entraînement (38) qui est couplé au premier élément optique (100 ; 104 ; 105 ; 107) de telle sorte qu'il bascule de façon oscillante le premier élément optique (100 ; 104 ; 105 ; 107) relativement au rayon lumineux d'éclairage (22 ; 79) pour modifier un angle d'incidence (108) du rayon lumineux d'éclairage (22 ; 79) sur le premier élément optique (100 ; 104 ; 105 ; 107) .

10. Dispositif selon l'une des revendications 8 à 9, **caractérisé en ce que** le dispositif (10 ; 44) présente un système d'entraînement (38) qui est couplé au premier élément optique (100 ; 104 ; 105 ; 107) de telle sorte qu'il fait tourner le premier élément optique (100 ; 104 ; 107) autour d'un axe qui est essentiellement parallèle à un axe optique (21) du verre de lunettes (16 ; 50).

11. Dispositif selon l'une des revendications 8 à 10, **caractérisé en ce que** le premier élément optique est une plaque (104) à faces planes et parallèles basculée par rapport à un axe optique (21) du verre de lunettes (16 ; 50), un prisme avec une surface de base (100) en forme de coin, une plaque (105) avec au moins une surface (106) ondulée ou un miroir (107), le dispositif présentant en particulier en outre un système d'entraînement (38) qui est couplé au miroir (107) de telle sorte qu'il fait tourner le miroir (107) de façon chancelante.

12. Dispositif selon l'une des revendications 8 à 11, **caractérisé en ce que** le dispositif (10 ; 44) présente en outre au moins un élément de guidage optique (24 ; 73, 80, 81, 82, 83, 85, 86) destiné à guider le rayon lumineux d'éclairage (22 ; 79) à travers le verre de lunettes (16 ; 50) et/ou destiné à guider vers la caméra (36 ; 87) le rayon lumineux d'observation (34 ; 85) réfléchi à travers le verre de lunettes (16 ; 50) par le réflecteur (30 ; 56).

13. Dispositif selon la revendication 12, **caractérisé en ce que** l'élément de guidage optique (24 ; 73, 80, 81, 82, 83, 85, 86) présente au moins un deuxième élément optique (24 ; 73, 80, 81, 82, 83) destiné à guider le rayon lumineux d'éclairage (22 ; 79) à travers le verre de lunettes (16 ; 50) ; et au moins un troisième élément optique (82, 83, 85, 86) destiné à guider vers la caméra (36 ; 87) le rayon lumineux d'observation (34 ; 85) réfléchi à travers le verre de lunettes (16 ; 50) par le réflecteur (30 ; 56) .

Fig.1

Fig.2

Fig.3

Fig.4

Fig.5

103

103ʹ

30

**Fig.6**

109

113

111

114

110

112

**Fig.7**

Fig.8a

Fig.8b

Fig.8c

Fig.8d

Fig.9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3892494 A
- US 4310242 A
- DE 4343345 A1
- EP 0169444 A2
- DE 19740391
- DE 10333426 A1
- JP 2006015447 A
- US 20110134417 A1
- EP 0856728 A2